# EUROPEAN PATENT APPLICATION

(11) **EP 2 924 720 A1**
(43) Date of publication of application: **30.09.2015**
(21) Application number: 15160453.5
(22) Date of filing: 24.03.2015
(51) Int. Cl.: H01L 21/67

(54) **SUBSTRATE PROCESSING APPARATUS AND RESIST REMOVING UNIT**

(30) Priority: 24.03.2014 JP 2014059566
(71) Applicant: Ebara Corporation, Tokyo 144-8510 (JP)
(72) Inventor: Kobayashi, Kenichi, Tokyo, 144-8510 (JP); Sekimoto, Masahiko, Tokyo, 144-8510 (JP); Yokohama, Toshio, Tokyo, 144-8510 (JP); Akazawa, Kenichi, Tokyo, 144-8510 (JP); Kurashina, Keiichi, Tokyo, 144-8510 (JP); Mitsuya, Takashi, Tokyo, 144-8510 (JP)
(74) Representative: Klang, Alexander H.

(57) **Abstract**

A substrate processing apparatus capable of inhibiting diffusion of a chemical solution atmosphere around a processing bath. The substrate processing apparatus has a processing bath for storing a substrate holder holding a substrate and for processing the substrate, a lifter configured to support the substrate holder, store the substrate holder in the processing bath, and take out the substrate holder from the processing bath, and a cover configured to cover the periphery of the substrate holder taken out from the processing bath by the lifter.

## Description

The present invention relates to a substrate processing apparatus that processes substrates such as semiconductor wafers and a resist removing unit.

Conventionally, wiring has been formed in fine wiring grooves, holes or resist openings that are provided on the surfaces of semiconductor wafers or the like, and bumps (protruding electrodes) which are electrically connected to electrodes on a packaging substrate or the like of packages have been formed on the surfaces of semiconductor wafers or the like. As the method for forming the wiring and the bumps, for example, an electrolytic plating method, a vapor deposition method, a printing method, a ball bump method and the like are known. With increase in the number of I/Os, and miniaturization of pitches of semiconductor chips of recent years, an electrolytic plating method which enables miniaturization and has relatively stable performance has come to be frequently used.

In the process of forming wiring in a resist opening by an electrolytic plating method, the wiring is formed in the resist opening, and thereafter, removal of resist formed on the substrate and etching of a seed layer (or a barrier metal) are performed.

The resist formed on the substrate is removed, for example, by immersing the substrate in a processing bath containing a chemical solution, e.g., an organic solvent. When the substrate is put in and taken out from the processing bath, a harmful chemical solution atmosphere diffuses, for example, as a result of evaporation of the chemical solution attached to the substrate.

The provision of a partition or an air curtain means at the boundary between a processing bath and another bath in a resist removing apparatus is known (see Japanese Utility Model Laid-Open No. 62-40825). The partition is obstructive to transport of substrates. There is a need to provide an opening for transport of substrates in the partition in order to avoid this problem. However, the opening may contribute to the diffusion of the chemical solution atmosphere. Also, an air curtain is not sufficiently effective in isolating the chemical solution atmosphere. In some cases, an air curtain may promote, rather than prevent, the diffusion of the chemical solution atmosphere.

Besides the resist removing apparatus, an etching apparatus may have a similar problem of diffusion of a harmful chemical solution atmosphere, depending on the kind of an etching solution. Also, with pre-wet processing or cleaning processing using iso-propyl alcohol (IPA), there is a problem of diffusion of evaporated IPS.

In view of the above-described problem, an object of the present invention is to inhibit diffusion of a chemical solution atmosphere around a processing bath.

According to a first aspect of the present invention, a substrate processing apparatus is provided. The substrate processing apparatus has a processing bath for storing a substrate holder holding a substrate and for processing the substrate, a lifter configured to support the substrate holder, store the substrate holder in the processing bath, and take out the substrate holder from the processing bath, and a cover configured to cover the periphery of the substrate holder taken out from the processing bath by the lifter.

According to a second aspect of the present invention, in the substrate processing apparatus according to the first aspect, the cover has a movable part and a cover drive section configured to open and close the cover by driving the movable part.

According to a third aspect of the present invention, the substrate processing apparatus according to the second aspect has a transferring device configured to transfer the substrate holder and deliver the substrate holder to the lifter or receive the substrate holder from the lifter, and the cover drive section opens the cover by driving the movable part when the transferring device delivers the substrate holder to the lifter or receives the substrate holder from the lifter.

According to a fourth aspect of the present invention, the substrate processing apparatus according to the third aspect has a fixed part to which one end of the movable part is attached, the cover has a hinge with which the one end of the movable part is turnably attached to the fixed part, and the cover drive section opens and closes the cover by turning the movable part on the hinge.

According to a fifth aspect of the present invention, in the substrate processing apparatus according to the third or fourth aspect, the transferring device has a grasping section configured to grasp the substrate holder, and a transferring section configured to transfer the substrate holder grasped by the grasping section, the grasping section is configured to grasp the substrate holder with a surface of the substrate oriented horizontally, and the transferring section is configured to transfer the substrate holder above the cover, with the surface of the substrate oriented horizontally.

According to a sixth aspect of the present invention, in the substrate processing apparatus according to the fifth aspect, the transferring device has a drive section configured to drive and turn the grasping section grasping the substrate holder so that the surface of the substrate is vertically oriented, and the lifter is configured to receive from the transferring device the substrate holder grasped in such a state that the surface of the substrate is vertically oriented.

According to a seventh aspect of the present invention, in the substrate processing apparatus according to any of the first to sixth aspects, the cover is positioned above the processing bath, and the cover has in its bottom portion an opening for storing the substrate holder in the processing bath positioned below or taking out the substrate holder from the processing bath.

According to an eighth aspect of the present invention, the substrate processing apparatus according to any of the first to seventh aspects has an exhaust section configured to exhaust gas from the interior of the cover.

According to a ninth aspect of the present invention, the substrate processing apparatus according to any one of the first to eighth aspects has a horizontal moving mechanism configured to move the lifter in a horizontal direction.

According to a tenth aspect of the present invention, in the substrate processing apparatus according to any one of the first to ninth aspects, the processing bath has a shutter capable of opening and closing the opening of the processing bath.

According to an eleventh aspect of the present invention, in the substrate processing apparatus according to any one of the first to tenth aspects, the processing bath is a bath for processing the substrate by using an organic solvent.

According to a twelfth aspect of the present invention, a resist removing unit is provided. The resist removing unit is provided with a first resist removing bath for storing a substrate holder holding a substrate and for processing the substrate, a second resist removing bath for storing a plurality of the substrate holders holding substrates processed in the first resist removing bath and for processing the substrates, and a third resist removing bath for storing the substrate holder holding the substrate processed in the second resist removing bath and for processing the substrate, the first resist removing bath has a spraying section configured to spray a processing solution to the substrate, and each of the second resist removing bath and the third resist removing bath contains a processing solution in which the substrate is to be immersed.

According to a thirteenth aspect of the present invention, in the resist removing unit according to the twelfth aspect, each of the first resist removing bath, the second resist removing bath and the third resist removing bath stores the substrate holder holding the substrate in such a manner that a surface of the substrate is vertically oriented.

According to a fourteenth aspect of the present invention, the resist removing unit according to the twelfth or thirteenth aspect has a substrate holder shifting mechanism configured to simultaneously move in a horizontal direction the plurality of the substrate holders stored in the second resist removing bath.

According to a fifteenth aspect of the present invention, in the resist removing unit according to the fourteenth aspect, the second resist removing bath has a mount on which the substrate holder is mounted, and the substrate holder shifting mechanism has a support part for supporting the substrate holder mounted on the mount, a vertical drive mechanism configured to drive the support part in a vertical direction, and a horizontal drive mechanism configured to drive the support part in a horizontal direction.

According to a sixteenth aspect of the present invention, in the resist removing unit according to any one of the twelfth to fifteenth aspects, the second resist removing bath has an opening for storing the substrate holder and a lid part for covering the opening, and the lid part has an inlet opening portion for storing the substrate holder in the opening, an outlet opening portion for taking out the substrate holder from the opening, and shutters for opening and closing the inlet opening portion and the outlet opening portion.

According to a seventeenth aspect of the present invention, the resist removing unit according to any one of the twelfth to sixteenth aspects has first piping connecting the first resist removing bath and the second resist removing bath, second piping connecting the second resist removing bath and the third resist removing bath, a first transport mechanism configured to transport a processing solution used in the second resist removing bath to the first resist removing bath through the first piping, and a second transport mechanism configured to transport a processing solution used in the third resist removing bath to the second resist removing bath through the second piping.

According to an eighteenth aspect of the present invention, in the resist removing unit according to any one of the twelfth to seventeenth aspects, at least one of the first resist removing bath, the second resist removing bath and the third resist removing bath has a to-and-fro movement mechanism configured to move the stored substrate holder to and fro in a vertical direction.

According to the present invention, diffusion of the chemical solution atmosphere around the processing bath can be inhibited.
FIG. 1 is a schematic plan view of a substrate processing apparatus according to one embodiment;
FIG. 2 is a schematic perspective view showing a fixing unit and an etching unit;
FIG. 3 is a perspective view of a substrate holder;
FIG. 4 is an enlarged perspective view of a holder section;
FIG. 5 is a schematic sectional side view of the fixing unit;
FIG. 6 is a perspective view of a substrate transfer device;
FIG. 7 is a side view of the substrate transfer device;
FIG. 8 is a top view of the substrate transfer device;
FIG. 9 is a partial enlarged view of a grasping mechanism;
FIG. 10 is a side view showing a state in which the grasping mechanism grasps the substrate holder;
FIG. 11 is a side view showing a state in which the grasping mechanism releases the substrate holder;
FIG. 12 is a perspective view showing the substrate transfer device including FFUs;
FIG. 13 is a side view showing the substrate transfer device including the FFUs;
FIG. 14 is a perspective view showing a lifter;
FIG. 15 is a perspective view of the lifter having a cover in an open state;
FIG. 16 is a perspective view of the lifter having a cover in a closed state;
FIG. 17 is a schematic sectional side view of the lifter, the substrate transfer device, the cover and a processing bath at the time of delivery of the substrate holder between the lifter and the substrate transfer device;
FIGS. 18A and 18B are schematic perspective views of the processing bath storing one or two substrate holders;
FIGS. 19A and 19B are schematic sectional views of a lid part taken along line 17-17 in FIGS. 18A and 18B;
FIGS. 20A and 20B are schematic side views of the processing bath storing a plurality of substrate holders;
FIG. 21 is a schematic diagram showing processing baths constituting the etching unit;
FIG. 22 is a schematic diagram showing another example of processing baths constituting the etching unit;
FIGS. 23A and 23B are diagrams showing comparison between the etching unit shown in FIG. 21 and the etching unit shown in FIG. 22;
FIG. 24 is a schematic diagram showing processing baths constituting a resist removing unit;
FIG. 25 is a schematic perspective view of a second stripping bath having the substrate holder shifting mechanism;
FIG. 26 is a plan view of the substrate holder indicating positions on arm portions of the substrate holder to be brought into contact with substrate holder mounts and the substrate holder support parts; and
FIGS. 27A to 27F are diagrams showing steps in which substrate holder shifting mechanisms shift the substrate holder.

An embodiment of the present invention will be described with reference to the drawings. In the drawings referred to below, components identical or corresponding to each other are assigned the same signs, and redundant descriptions of them are omitted.

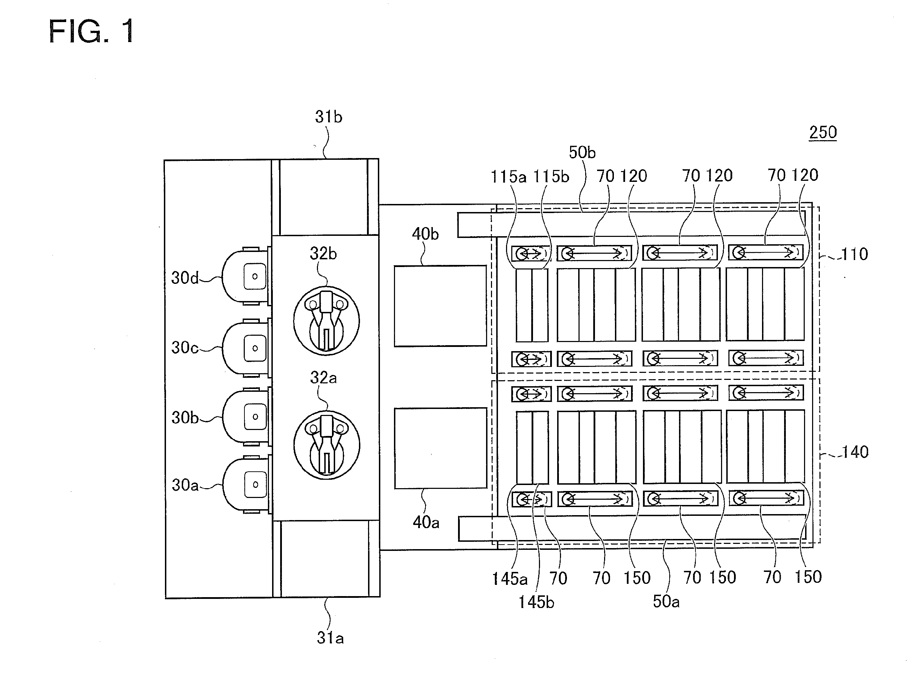

FIG. 1 is a schematic plan view of the substrate processing apparatus according to an embodiment of the present invention.

As shown in FIG. 1, in a substrate processing apparatus 250, four cassettes 30a, 30b, 30c and 30d that store substrates such as semiconductor wafers, two substrate dryers 31a and 31b that dry the substrates after processing, fixing units 40a and 40b that attach and detach substrates to and from substrate holders, and two robot hands 32a and 32b that transfer substrates to and from these units are disposed. Note that in positions where the substrate dryers 31a and 31b are disposed, two substrate dryers are respectively disposed in a vertical direction, so that four substrate dryers may be disposed in the substrate processing apparatus 250.

A substrate to be processed in a resist removing unit 140 which will be described later is taken out by the robot hand 32a from the cassette 30a or the cassette 30b, and is transferred to the fixing unit 40a. The substrate which is mounted on a substrate holder in the fixing unit 40a is thereafter in the resist removing unit 140 to remove a resist. The substrate from which the resist is removed in the resist removing unit 140 is taken out from the substrate holder in the fixing unit 40a. The substrate which is taken out from the substrate holder is transferred to the substrate dryer 31a from the fixing unit 40a by the robot hand 32a. The substrate is cleaned and dried with use of IPA and DIW (De-Ionized Water) by the substrate dryer 31a. The dried substrate is returned to the cassette 30a or the cassette 30b by the robot hand 32a.

Likewise, a substrate to be subjected to etching processing in an etching unit 110 that will be described later is taken out from the cassette 30c or the cassette 30d by the robot hand 32b, and is transferred to the fixing unit 40b. The substrate which is mounted on the substrate holder in the fixing unit 40b is subjected to etching processing in the etching unit 110 thereafter. The substrate to which etching processing is applied in the etching unit 110 is taken out from the substrate holder in the fixing unit 40b. The substrate which is taken out from the substrate holder is transferred to the substrate dryer 31b from the fixing unit 40b by the robot hand 32b. The substrate is cleaned and dried with use of IPA and DIW by the substrate dryer 31b. The dried substrate is returned to the cassette 30c or the cassette 30d by the robot hand 32b.

Further, in the substrate processing apparatus 250, the resist removing unit 140 which performs processing of removing the resist formed on a substrate is provided. The resist removing unit 140 includes two pre-wet baths 145a and 145b for increasing hydrophilicity of a substrate surface, and three resist removing modules 150 for removing the resist formed on a substrate. The resist removing module 150 are each constructed of a plurality of baths. The pre-wet baths 145a and 145b include lifters 70 that store or take out the substrate holders into or from the pre-wet baths 145a and 145b and are horizontally movable, along both sides of the baths. Likewise, the resist removing module 150 includes the lifters 70 which store or take out the substrate holders into or from the plurality of baths constructing the resist removing module 150, along both sides of the baths. Further, the resist removing unit 140 includes a substrate transfer device 50a (corresponding to one example of a transferring device) that transfers substrates to and from the fixing unit 40a, the lifters 70 included by the pre-wet baths 145a and 145b, and the lifters 70 included by the resist removing modules 150.

When the resist on a substrate is removed, the substrate holder holding the substrate is transferred to the substrate transfer device 50a from the fixing unit 40a, and is transferred to the lifters 70 included by the pre-wet baths 145a or 145b by the substrate transfer device 50a. The lifters 70 store the transferred substrate holder into a vacant bath out of the pre-wet bath 145a and the pre-wet bath 145b. DIW and IPA are sprayed to the substrate in the pre-wet bath 145a or the pre-wet bath 145b. After the substrate is processed in the pre-wet bath 145a or the pre-wet bath 145b, the substrate holder is taken out from the pre-wet bath 145a or the pre-wet bath 145b by the lifters 70, and is transferred to the substrate transfer device 50a. The substrate holder is transferred to the lifters 70 of any one of the resist removing modules 150 by the substrate transfer device 50a, and is stored into the processing bath of the resist removing module 150 by the lifters 70. After the substrate is processed in the resist removing module 150, the substrate holder is taken out from the processing bath by the lifters 70 of the resist removing module 150, and is transferred to the substrate transfer device 50a. The substrate holder is returned to the fixing unit 40a by the substrate transfer device 50a.

Further, in the substrate processing apparatus 250, an etching unit 110 that performs etching of a seed layer formed on a substrate is provided. The etching unit 110 includes two pre-wet baths 115a and 115b for enhancing hydrophilicity of a substrate surface, and three etching modules 120 for etching the seed layer formed on the substrate. The etching modules 120 are each constructed of a plurality of baths. The pre-wet baths 115a and 115b include the lifters 70 which store or take out a substrate holder into or from the pre-wet baths 115a and 115b, along both sides of the baths. Likewise, the etching module 120 includes the lifters 70 that store or take out a substrate holder into or from the plurality of baths constructing the etching module 120, along both sides of the baths. Further, the etching unit 110 includes a substrate transfer device 50b (corresponding to one example of the transferring machine) that transfers a substrate to and from the fixing unit 40b, the lifters 70 included by the pre-wet baths 115a and 115b, and the lifters 70 included by the etching modules 120.

When the seed layer of a substrate is etched, the substrate holder holding a substrate is transferred from the fixing unit 40b to the substrate transfer device 50b, and is transferred to the lifters 70 included by the pre-wet baths 115a and 115b by the substrate transfer device 50b. The lifter 70 stores the transferred substrate holder into a vacant bath out of the pre-wet bath 115a and the pre-wet bath 115b. In the pre-wet bath 115a or the pre-wet bath 115b, DIW or IPA is sprayed to the substrate. After the substrate is processed in the pre-wet bath 115a or the pre-wet bath 115b, the substrate holder is taken out from the pre-wet bath 115a or the pre-wet bath 115b by the lifters 70, and is transferred to the substrate transfer device 50b. The substrate holder is transferred to the lifters 70 of any one of the etching modules 120 by the substrate transfer device 50b, and is stored into the processing bath of the etching module 120 by the lifters 70. After the substrate is processed in the etching module 120, the substrate holder is taken out from the processing bath by the lifters 70 of the etching module 120, and is transferred to the substrate transfer device 50b. The substrate holder is returned to the fixing unit 40b by the substrate transfer device 50b.

As illustrated, in the substrate processing apparatus 250, with respect to the cassettes 30a and 30d, the substrate dryer 31a, the robot hand 32a, the fixing unit 40a and the resist removing unit 140, the cassettes 30c and 30d, the substrate dryer 31b, the robot hand 32b, the fixing unit 40b and the etching unit 110 are configured to be in a substantially symmetrical positional relation.

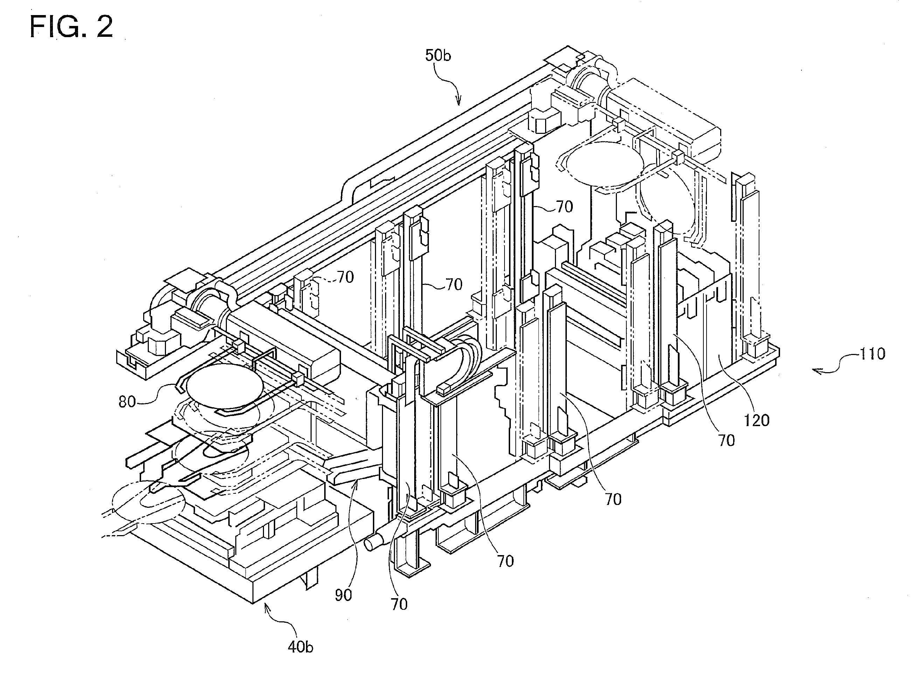

Next, a positional relation of the fixing unit 40b and the etching unit 110 shown in FIG. 1 will be described. FIG. 2 is a schematic perspective view showing the fixing unit 40b and the etching unit 110 shown in FIG. 1. Note that in FIG. 2, illustration of the pre-wet baths 115a and 115b and the two etching modules 120 is omitted for convenience.

As illustrated, the fixing unit 40b and the etching unit 110 are disposed to be aligned in a straight line. The pre-wet baths 115a and 115b (not illustrated) and the three etching modules 120 (only one of them is illustrated) respectively include the lifters 70 disposed along an aligned direction, at lateral sides of the baths. Each of the lifters 70 is configured to be movable in the horizontal direction, from one end to the other end of each of the processing baths. That is to say, the respective lifters 70 can move to positions of the lifters 70 shown by broken lines in the drawing.

The substrate transfer device 50b transfers a substrate holder 80 so that the substrate holder 80 passes above the fixing unit 40b and the etching unit 110. Each of the lifters 70 includes a cover 90 which is configured to cover a periphery of the substrate holder 80 which is supported by the lifters 70. Note that in the lifters 70 of the etching module 120 in the drawing, the covers 90 are not illustrated.

The fixing unit 40a and the resist removing unit 140 shown in FIG. 1 also have a positional relation similar to the fixing unit 40b and the etching unit 110 shown in FIG. 2, except that the position of the substrate transfer device 50a differs. Accordingly, explanation of the positional relation of the fixing unit 40a and the resist removing unit 140 will be omitted.

The substrate holder 80, the fixing unit 40b, the substrate transfer device 50a, the lifter 70, the cover 90 and the etching unit 110 shown in FIG. 2 and the resist removing unit 140 shown in FIG. 1 will be successively described in detail.

### <Substrate holder>

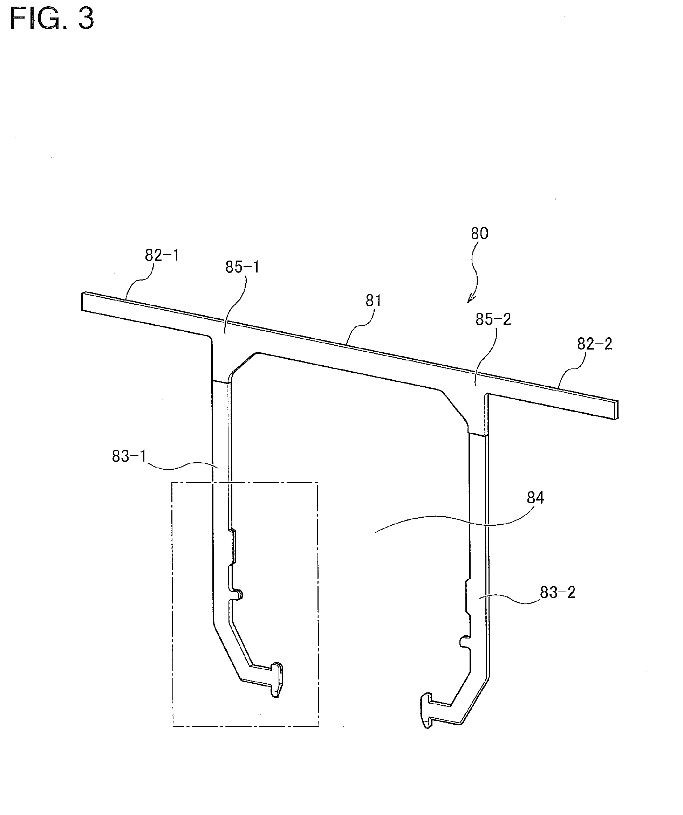

FIG. 3 is a perspective view of the substrate holder 80. As illustrated, the substrate holder 80 has a base portion 81 that is a board-shaped member formed to be elongated, two arm portions 82-1 and 82-2 that are board-shaped members formed by extending from both ends of the base portion 81, and two holder portions 83-1 and 83-2 for holding a substrate. Spots where the base portion 81, the arm portions 82-1 and 82-2 and the holder portions 83-1 and 83-2 intersect one another are grasped portions 85-1 and 85-2 of the substrate holder 80, and the grasped portions 85-1 and 85-2 are grasped by the substrate transfer device 50. The arm portions 82-1 and 82-2 are board-shaped members which are formed by extending from both the ends of the base portion 81. The arm portions 82-1 and 82-2 are portions that are suspended on side walls of a processing bath when the substrate holder 80 is dipped into the processing bath as will be described later, and are portions that are supported by the lifters 70. The holder portions 83-1 and 83-2 are board-shaped members in substantially L-shapes that are formed in substantially perpendicular directions to a longitudinal direction of the base portion 81, from both the ends of the base portion 81. The substrate holder 80 can accommodate and hold a substrate such as a semiconductor wafer in a space 84 between the holder portion 83-1 and the holder portion 83-2.

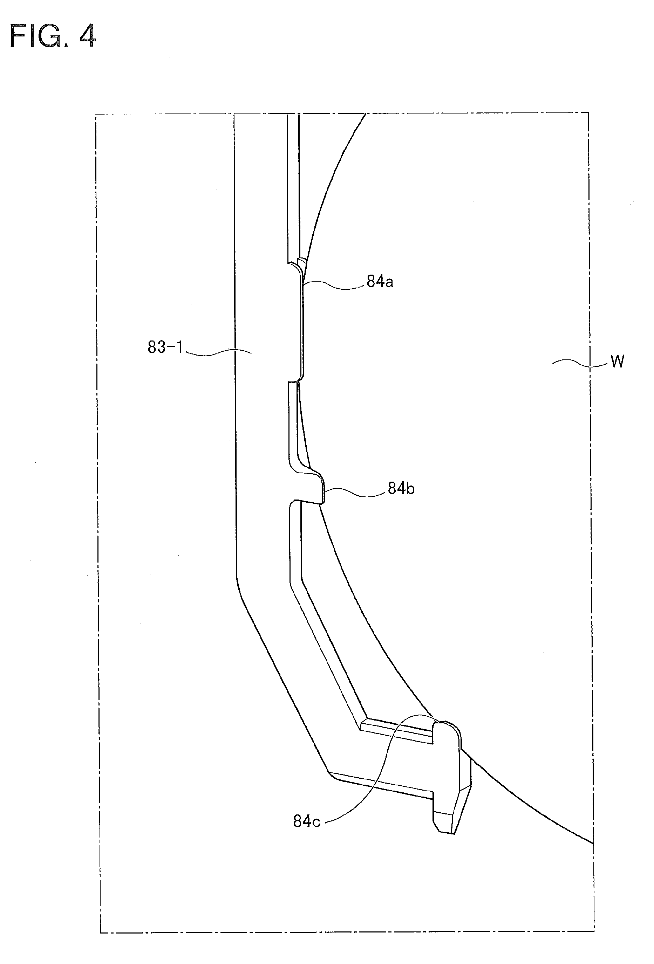

FIG. 4 is an enlarged perspective view of the holder portion 83-1 shown in FIG. 3. FIG. 4 shows a state in which the substrate holder 80 holds a substrate. The holder portion 83-1 has a plurality of slits 84a, 84b and 84c along a surface facing the holder portion 83-2, namely, the surface facing the space 84 shown in FIG. 3. Further, the holder portion 83-2 also has a plurality of slits similar to the slits in the holder portion 83-1 along a surface facing the holder portion 83-1, though not illustrated. An outer circumferential portion of a substrate W is fitted into the slits 84a, 84b and 84c of the holder portion 83-1 and the slits of the holder portion 83-2, and thereby the substrate W is held by the substrate holder 80. Thereby, the substrate W can be restrained from dropping from the substrate holder 80 when the substrate holder 80 is made horizontal.

### <Fixing unit>

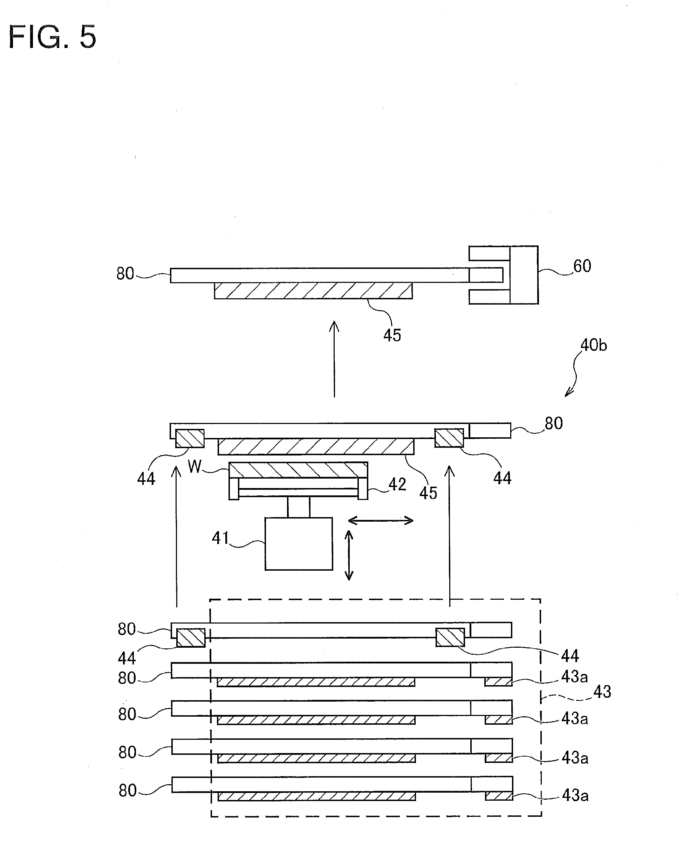

FIG. 5 is a schematic sectional side view of the fixing unit 40b shown in FIG. 2. Note that the fixing unit 40a also has a similar structure, and therefore, explanation will be omitted. The fixing unit 40b includes a holder stocker 43 capable of storing a plurality of substrate holders 80 that do not hold a substrate, a hand 42 for attaching and detaching the substrate W to and from the substrate holder 80, and a drive mechanism 41 for moving the hand 42 in the vertical direction and the horizontal direction.

The fixing unit 40b further includes movable holder receiving claws 44 for taking out the substrate holder 80 stored in the holder stocker 43 to move the substrate holder 80 to a predetermined position, and a movable holder support 45 for receiving the substrate holder 80 from the holder receiving claws 44 to move the substrate holder 80 further to another position.

The holder stocker 43 has a plurality of support shelves 43a formed in the horizontal direction therein. That is to say, slits are formed among the plurality of support shelves 43a. The substrate holder 80 which does not hold a substrate is inserted into the slit and is horizontally supported by the support shelf 43a.

The holder receiving claws 44 hold the holder portions 83-1 and 83-2 (see FIG. 3) of the substrate holder 80 at four spots, for example, from both outer sides. The holder receiving claws 44 can perform an opening and closing operation in a state holding the holder portions 83-1 and 83-2, and in a state separating from the holder portions 83-1 and 83-2. Further, the holder receiving claws 44 can move vertically between a position where the substrate holder receives the substrate W from the hand 42, and the holder stocker 43.

The holder support 45 supports the substrate holder 80 from below and receives the substrate holder 80 from the holder receiving claws 44, in a position where the substrate holder 80 receives the substrate W from the hand 42. The holder support 45 lifts up the substrate holder 80, which is received from the holder receiving claws 44, to a position where a pair of holder clamps 60 of the substrate transfer device 50a or 50b grasps the substrate holder 80 (see FIG. 2).

When the substrate W is mounted on the substrate holder 80, the substrate holder 80 is first transferred to a position above the hand 42 from the holder stocker 43 by the holder receiving claws 44. The drive mechanism 41 raises the hand 42 which supports the substrate W from below and positions the substrate W in the space 84 (see FIG. 4) of the substrate holder 80. Subsequently, the drive mechanism 41 moves the hand 42 which supports the substrate W in the horizontal direction, and fits the substrate W into the slits 84a, 84b and 84c shown in FIG. 4. The substrate holder 80 on which the substrate W is mounted is transferred to the holder support 45 from the holder receiving claws 44, and is moved to a transfer position to the holder clamp 60 by the holder support 45. Thereafter, the substrate holder 80 is grasped by the holder clamp 60, and is transferred to a processing bath of a subsequent stage.

When the substrate W which is processed is detached from the substrate holder 80, the substrate holder 80 which is grasped by the holder clamp 60 is first transferred to the holder support 45. Thereafter, the holder support 45 lowers, and the substrate holder 80 is transferred to the holder receiving claws 44. In a position where the substrate holder 80 is transferred to the holder receiving claws 44, the substrate W is detached from the substrate holder 80 by the hand 42. The substrate holder 80 from which the substrate W is detached is returned to the holder stocker 43 by the holder receiving claws 44.

### <Substrate transfer device>

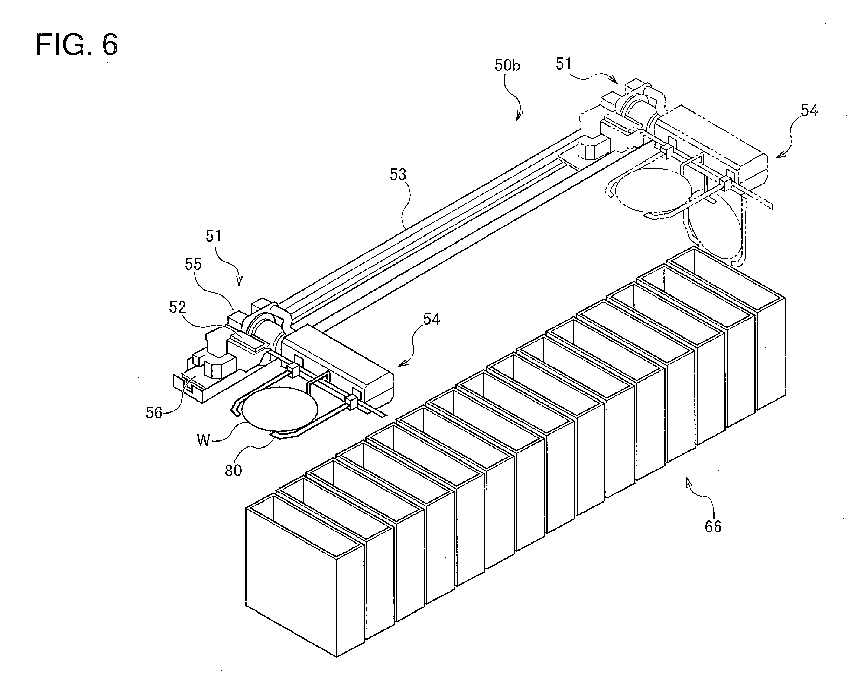

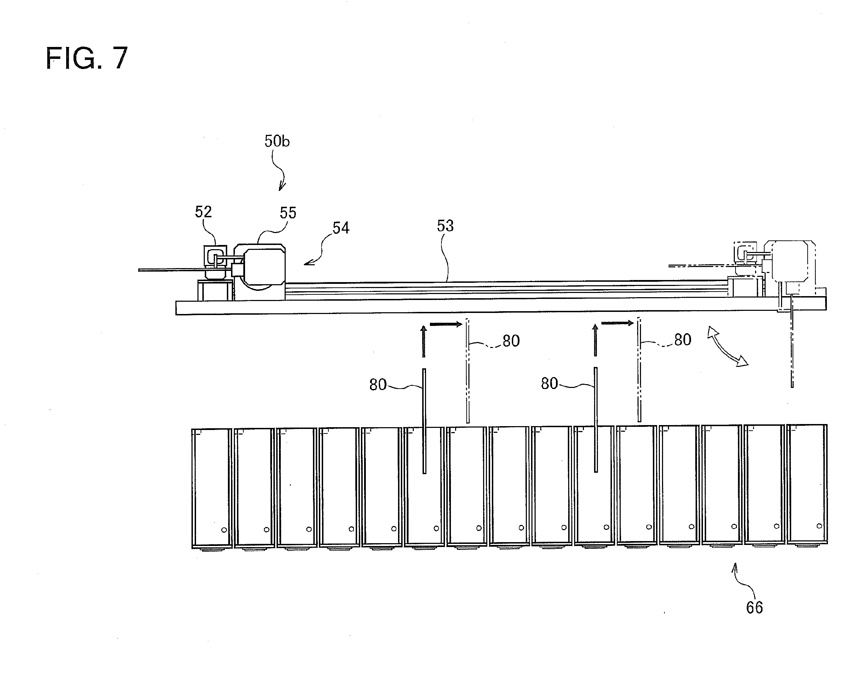

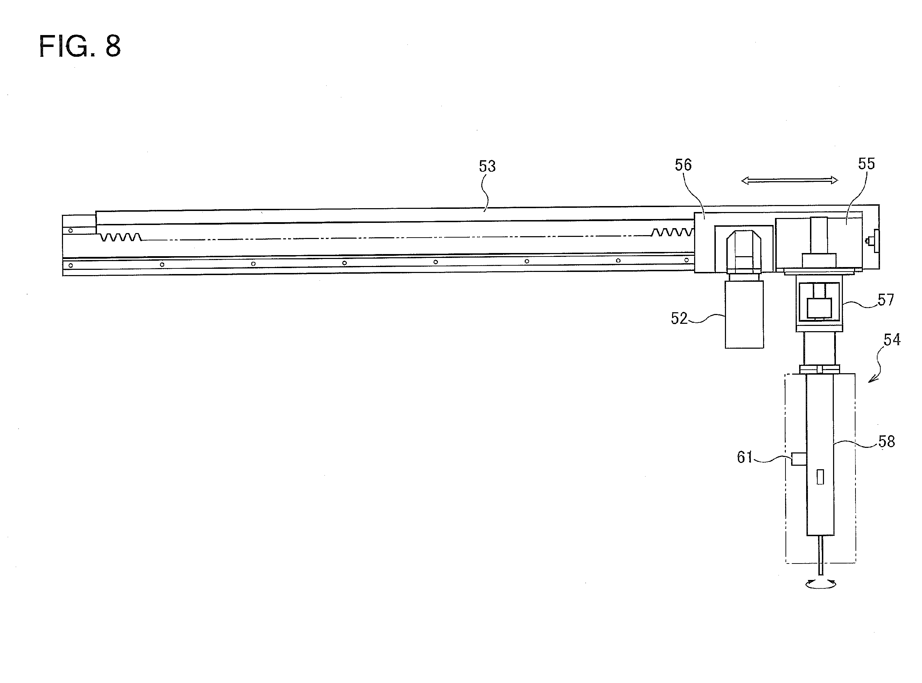

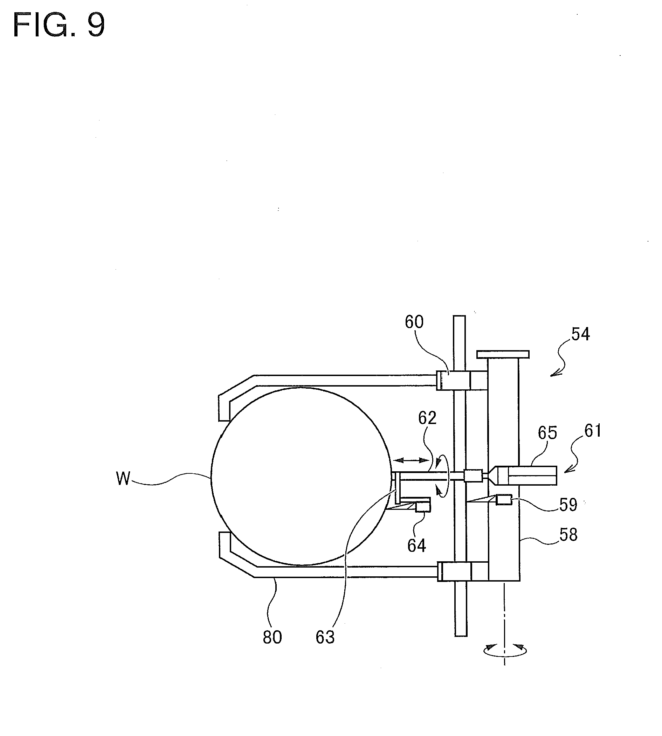

Subsequently, the substrate transfer device 50b shown in FIG. 2 will be described. Note that the substrate transfer device 50a has a construction similar to that of the substrate transfer device 50b, and therefore, explanation will be omitted. FIG. 6 is a perspective view of the substrate transfer device 50b shown in FIG. 2. FIG. 7 is a side view of the substrate transfer device 50b. FIG. 8 is a top view of the substrate transfer device 50b. FIG. 9 is a partial enlarged view of a grasping mechanism. In FIGS. 6 and 7, a processing bath 66 is shown for convenience of explanation of the positional relation with the substrate transfer device 50b. The processing bath 66 shows the pre-wet bath 115, the etching module 120 and the like shown in FIG. 1 in an abbreviated manner, and the number of baths differs from what is shown in FIG. 1.

As shown in FIGS. 6 and 7, the substrate transfer device 50b has a grasping mechanism 54 (corresponding to one example of a grasping section) for grasping the substrate holder 80, and a transfer mechanism 51 (corresponding to one example of a transferring section) for transferring the substrate holder 80 which is grasped by the grasping mechanism 54. The transfer mechanism 51 has a travel base 56 to which the grasping mechanism 54 is attached, a guide rail 53 for guiding the travel base 56, and a travel motor 52 for causing the travel base 56 to travel on the guide rail 53. As shown by the broken lines in the drawings, the grasping mechanism 54 grasping the substrate holder 80 can travel along the guide rail 53 from one end to the other end of the guide rail 53 by the transfer mechanism 51. The grasping mechanism 54 grasps the substrate holder 80 while an in-plane direction of the substrate W is horizontally oriented. The travel motor 52 drives in this state, whereby the travel base 56 travels along the guide rail 53. Thereby, the transfer mechanism 51 transfers the substrate holder 80 so that the substrate holder 80 passes above the processing bath 66 while the in-plane direction of the substrate W is horizontally oriented. By the by, the term "in-plane direction of the substrate W" has same meaning as "the surface of the substrate W," which will be apparently understood from Fig.7, etc, and the description below.

Further, the substrate transfer device 50b has a rotary motor 55 (corresponding to one example of a drive section) that rotates the grasping mechanism 54. The rotary motor 55 rotates the grasping mechanism 54 grasping the substrate holder 80 while the in-plane direction of the substrate W is horizontally oriented by approximately 90 degrees so that the in-plane direction of the substrate W is vertically oriented. The substrate holder 80 is transferred to the lifters 70 shown in FIG. 2 from the grasping mechanism 54 while the substrate holder 80 is vertically oriented, that is, while the in-plane direction of the substrate W held by the substrate holder 80 is vertically oriented. The substrate holder 80 which is transferred to the lifters 70 is stored into the processing bath 66 by the lifters 70.

Further, the rotary motor 55 can rotate the grasping mechanism 54 which grasps the substrate holder 80 while the in-plane direction of the substrate W is vertically oriented by approximately 90 degrees so that the in-plane direction of the substrate W is horizontally oriented. The substrate holder 80 is transferred to the grasping mechanism 54 from the lifters 70 shown in FIG. 2, while the substrate holder is vertically oriented. The substrate holder 80 which is transferred to the grasping mechanism 54 is rotated so that the substrate W is oriented in the horizontal direction by the rotary motor 55 rotating the grasping mechanism 54.

FIG. 7 shows a process in which the substrate holder 80 is taken out from the processing bath 66 and is stored into the adjacent processing bath 66, by the lifters 70 (not illustrated). The substrate transfer device 50b transfers the substrate holder 80 while the in-plane direction of the substrate W is horizontally oriented, and therefore, even when another substrate holder 80 is taken out from or stored into the processing bath 66, the substrate holder 80 can pass above the other substrate holder.

As shown in FIGS. 8 and 9, the grasping mechanism 54 has a rotary shaft 58 configured to be rotatable by the rotary motor 55, and a coupling 57 for coupling an output shaft not illustrated of the rotary motor 55 and the rotary shaft 58. The grasping mechanism 54 can change an orientation of the grasped substrate holder 80 between the vertical direction and the horizontal direction by the rotary shaft 58 being rotated in a circumferential direction thereof by the rotary motor 55.

Furthermore, as shown in FIG. 9, the grasping mechanism 54 has a pair of holder clamps 60 provided at the rotary shaft 58, a substrate pressing 61 (corresponding to one example of a pressing member) that presses the substrate W to the substrate holder 80, and a holder detecting sensor 59 that detects presence or absence of the substrate holder 80. The holder clamps 60 grasp the grasped portions 85-1 and 85-2 (see FIG. 3) of the substrate holder 80. The holder detecting sensor 59 is, for example, an optical sensor or a magnetic sensor for detecting presence or absence of the substrate holder 80 when the holder clamps 60 grasp the substrate holder 80.

The substrate presser 61 has a shaft portion 62, an air cylinder 65 that is configured to slide the shaft portion 62 in an axial direction and rotates the shaft portion 62 in a circumferential direction, a pressing portion 63 that is in contact with the substrate W to press the substrate W to the substrate holder 80, and a substrate detecting sensor 64 that detects presence or absence of the substrate W. The shaft portion 62 has one end coupled to the air cylinder 65, and the other end coupled to the pressing portion 63. The pressing portion 63 is a rod-shaped member that has one end coupled to the above described other end of the shaft portion 62, and the other end extending in a substantially perpendicular direction to the axial direction of the shaft portion 62. The substrate detecting sensor 64 is, for example, an optical sensor or a magnetic sensor that is fixed to the other end of the pressing portion 63 via fixing means.

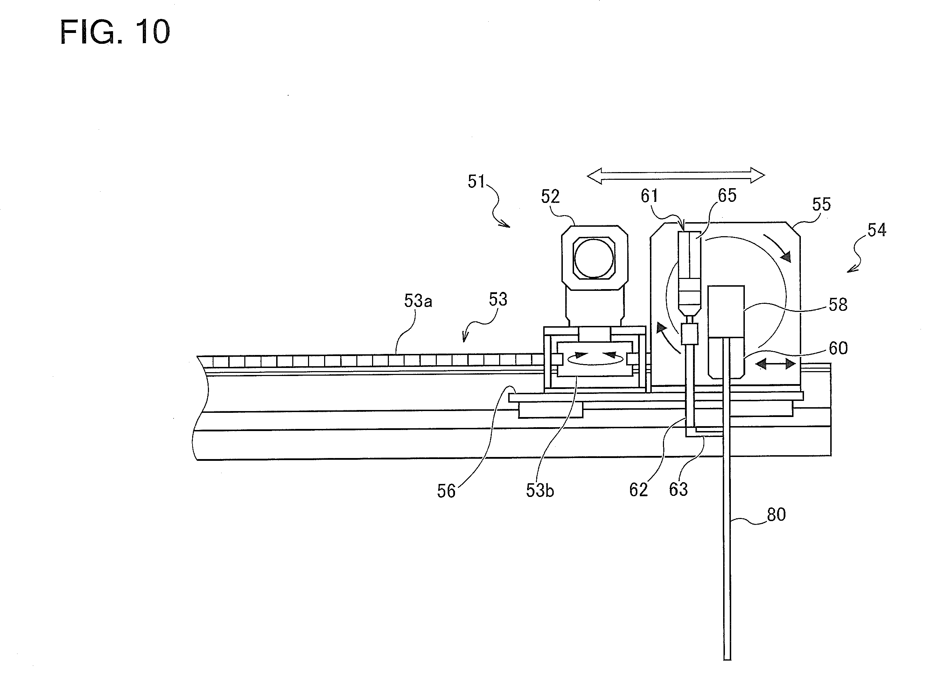

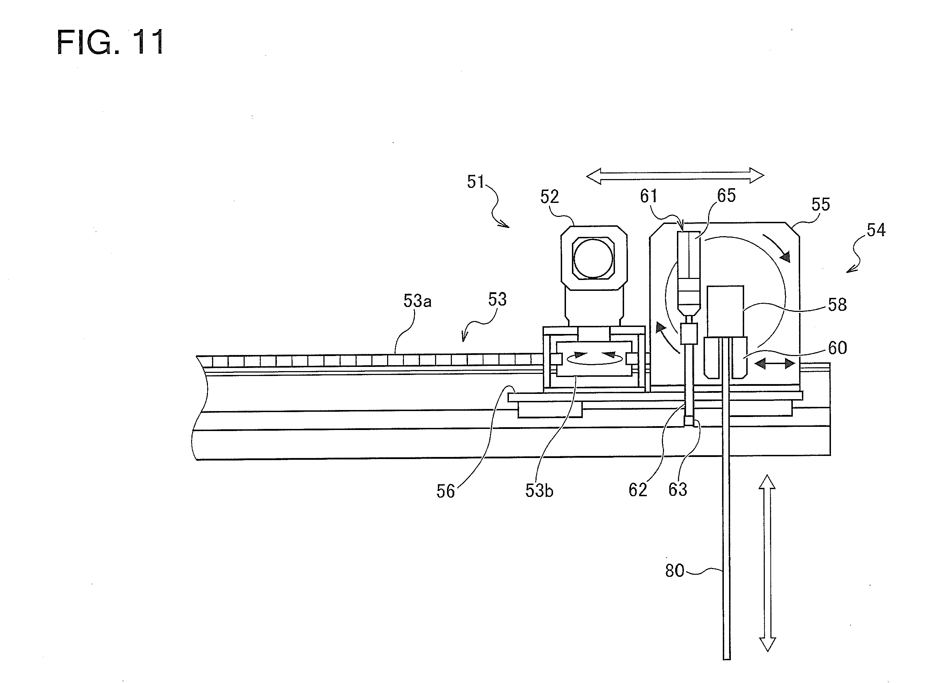

FIG. 10 is a side view showing a state in which the grasping mechanism 54 grasps the substrate holder 80. FIG. 11 is a side view showing a state in which the grasping mechanism 54 releases grasp on the substrate holder 80. As shown in FIG. 10, when the holder clamps 60 of the grasping mechanism 54 grasp the substrate holder 80, the substrate presser 61 turns the pressing portion 63 by the air cylinder 65 so that the pressing portion 63 is positioned on an edge of the substrate W. Subsequently, the shaft portion 62 is slid in the axial direction by the air cylinder 65, the pressing portion 63 is in contact with the edge of the substrate W, and the substrate W is pressed to the substrate holder 80.

As shown in FIG. 11, when the holder clamps 60 release grasp on the substrate holder 80, the air cylinder 65 of the substrate pressing 61 moves the shaft portion 62 upward, and turns the pressing portion 63 to release contact of the pressing portion 63 with the substrate W. Subsequently, when the grasping mechanism 54 transfers the substrate holder 80 to the lifters 70 not illustrated, the grasping mechanism 54 releases grasp of the holder clamps 60 on the substrate holder 80.

Note that as shown in FIGS. 10 and 11, the guide rail 53 of the transfer mechanism 51 includes a rack 53a along a rail direction thereof. Further, the transfer mechanism 51 has a pinion 53b that is configured to be rotatable by the travel motor 52. That is to say, the transfer mechanism 51 can cause the travel base 56 to travel along the guide rail 53 by a rack and pinion mechanism.

Next, a process of the substrate transfer device 50b transferring the substrate W will be described. The grasping mechanism 54 of the substrate transfer device 50b receives the substrate holder 80 holding the substrate W from the fixing unit 40b shown in FIG. 5 while the in-plane direction of the substrate W is horizontally oriented, that is, while the substrate holder 80 is in a horizontal state. The transfer mechanism 51 transfers the substrate holder 80 by passing the substrate holder 80 above the processing bath 66 while the in-plane direction of the substrate W is horizontally oriented. The transfer mechanism 51 stops the grasping mechanism 54 directly above the predetermined processing bath 66. The grasping mechanism 54 turns the substrate holder 80 so that the in-plane direction of the substrate W is vertically oriented. The lifters 70 shown in FIG. 2 receive the substrate holder 80 from the grasping mechanism 54 while the in-plane direction of the substrate W is vertically oriented. The lifters 70 store the received substrate holder 80 into the processing bath 66 while the in-plane direction of the substrate W is vertically oriented.

Subsequently, when the substrate holder 80 is transferred from the processing bath 66, the lifters 70 shown in FIG. 2 take out the substrate holder 80 from the processing bath 66. The grasping mechanism 54 of the substrate transfer device 50b receives the substrate holder 80 from the lifters 70 while the in-plane direction of the substrate W is vertically oriented. The grasping mechanism 54 turns the substrate holder 80 so that the in-plane direction of the substrate W is horizontally oriented. The transfer mechanism 51 causes the substrate holder 80 to pass above the processing bath 66, and transfers the substrate holder 80 to the processing bath 66 where a subsequent process is performed or the fixing unit 40b, while the in-plane direction of the substrate W is horizontally oriented.

As described above, in the substrate transfer devices 50a and 50b, the transfer mechanism 51 transfers the substrate holder 80 by passing the substrate holder 80 above the processing bath 66, while the in-plane direction of the substrate W is horizontally oriented, and therefore, a space in the vertical direction that is required for transfer of the substrate holder 80 can be made small. Therefore, even while another substrate holder 80 is stored into the processing bath 66, or another substrate holder 80 is taken out from the processing bath 66, the substrate holder 80 can be transferred by being passed above the other substrate holder 80. Accordingly, even while the substrate holder 80 is put in or taken out from the processing bath 66, transfer of another substrate holder 80 does not have to be awaited, and therefore, the throughput of the substrate processing apparatus 250 can be improved. Further, since the substrate holder 80 is transferred in the horizontal direction while the in-plane direction of the substrate W is horizontally oriented, air resistance received by the substrate W by transfer can be reduced, and the substrate holder 80 can be transferred at a relatively high speed. Note that "the in-plane direction of the substrate W is horizontally oriented" is not limited to the case where the in-plane direction of the substrate W is oriented completely in the horizontal direction, but also includes a case where the in-plane direction of the substrate W has a slight angle to the horizontal direction.

In particular, when the lifters 70 which move the substrate holder 80 vertically with respect to the processing bath 66, and puts and takes out the substrate holder 80 in and from the processing bath 66 are provided as in the substrate processing apparatus 250 according to the present embodiment, processing of putting in and taking out of the substrate holder 80 by the lifters 70, and transfer of other substrate holders 80 by the substrate transfer devices 50a and 50b can be performed at independent timings respectively without interfering with one another. Accordingly, even while the lifters 70 put and take out the substrate holder 80 in and from the processing bath 66, transfer of other substrate holders 80 by the substrate transfer devices 50a and 50b does not have to be awaited, and therefore, the throughput of the substrate processing apparatus 250 can be improved. That is to say, an operation of the lifters 70 putting and taking out the substrate holder 80 in and from the processing bath 66 in one of the etching modules 120, for example, and an operation of the substrate transfer devices 50a and 50b transferring other substrate holders 80 to other etching modules 120 above the one etching module 120, or collecting other substrate holders 80 from the other etching modules 120 can be independently performed without waiting for mutual operations.

Further, the substrate transfer devices 50a and 50b have the rotary motors 55 which rotationally drive the grasping mechanisms 54 grasping the substrate holders 80 so that the in-plane directions of the substrates W are vertically oriented. Accordingly, even when the processing bath 66 stores the substrate holder 80 in the vertical direction, the substrate transfer devices 50a and 50b can transfer the substrate holders 80 to the lifters 70 while the in-plane directions of the substrates W are vertically oriented, and the substrate holders 80 can be easily stored into the processing baths 66. Note that "the in-plane direction of the substrate W is vertically oriented" in this case is not limited to the case where the in-plane direction of the substrate W is oriented completely in the vertical direction, but also includes a case where the in-plane direction of the substrate W has a slight angle to the vertical direction.

Further, the grasping mechanism 54 has the substrate pressing 61 which presses the substrate W to the substrate holder 80, and therefore, even when the substrate holder 80 is transferred so that the in-plane direction of the substrate W is horizontally oriented, the substrate W can be restrained from dropping from the substrate holder 80.

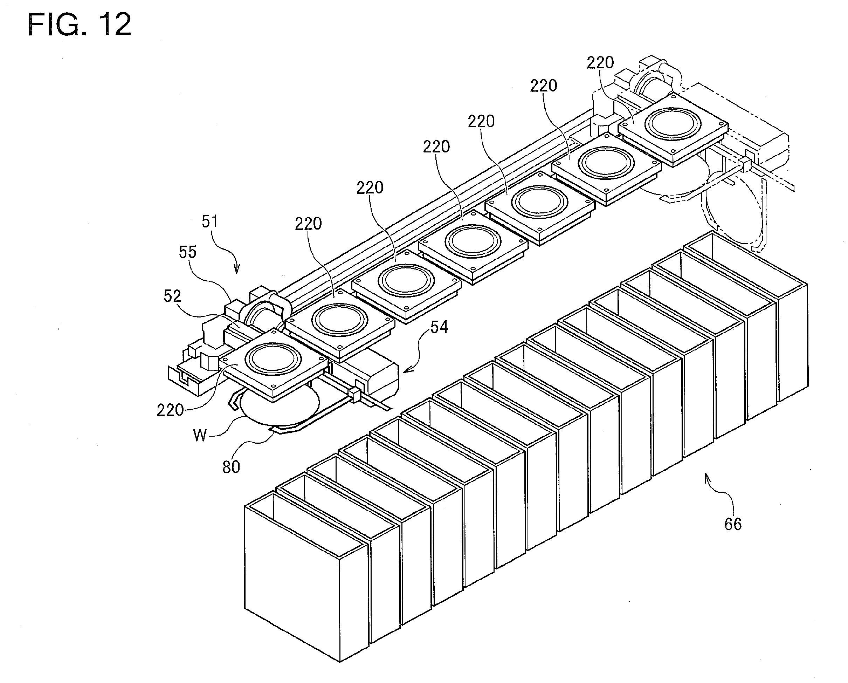

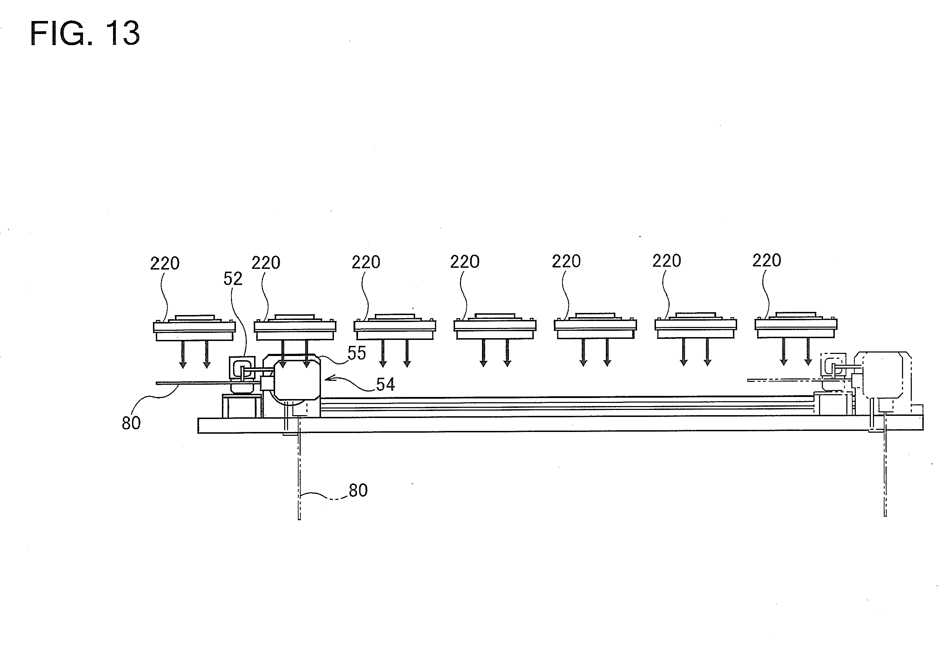

FIG. 12 is a perspective view showing the substrate transfer device 50b including FFUs (fan filter units), and FIG. 13 is a side view showing the substrate transfer device 50b including the FFUs. The substrate transfer devices 50a and 50b according to the present embodiment can additionally include FFUs 220 shown in FIGS. 12 and 13. The FFU 220 (corresponding to one example of a blowing mechanism) is a fan in which a filter is incorporated, and as shown in FIG. 12, a plurality of FFUs 220 are disposed along above a path on which the substrate holder 80 is transferred. The FFU 220 is connected to a duct or the like not illustrated, for example, and is configured to blow gas such as air from the duct or the like downward through a filter.

As shown in FIG. 13, the FFU 220 is provided at a position higher than the substrate holder 80 which is transferred. The FFU 220 blows out the gas through the filter downward, whereby particles and the like in an atmosphere can be prevented from rising into an upper space of the substrate processing apparatus 250. Accordingly, particles are restrained from attaching to the substrate W held by the substrate holder 80 which is transferred. Further, the grasping mechanism 54 is configured to grasp the substrate holder 80 in such a manner that a processed surface of the substrate W faces upward. Thereby, the particles can be more restrained from attaching to the processed surface of the substrate W.

### <Lifter>

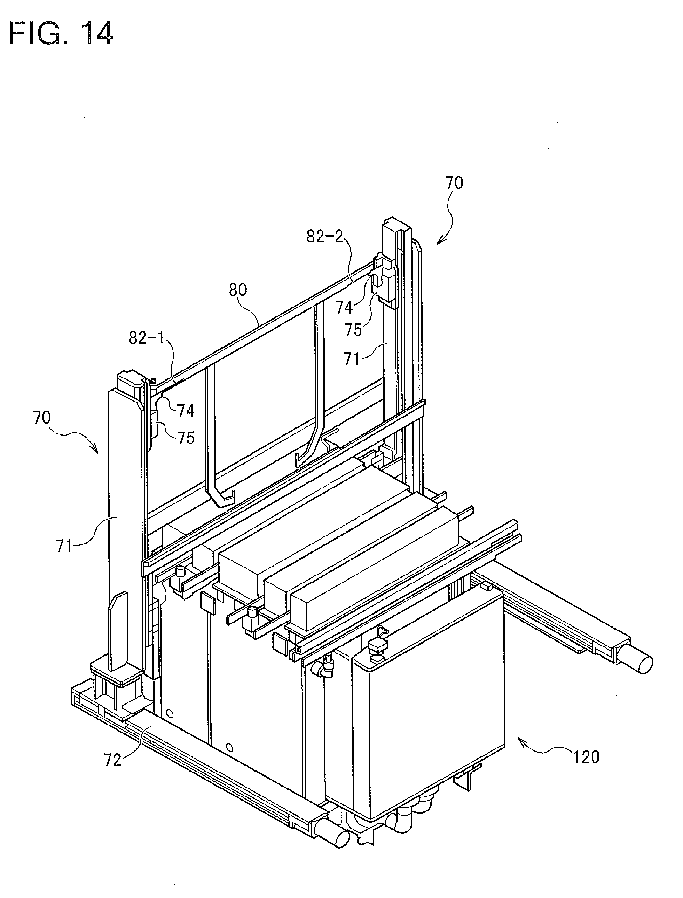

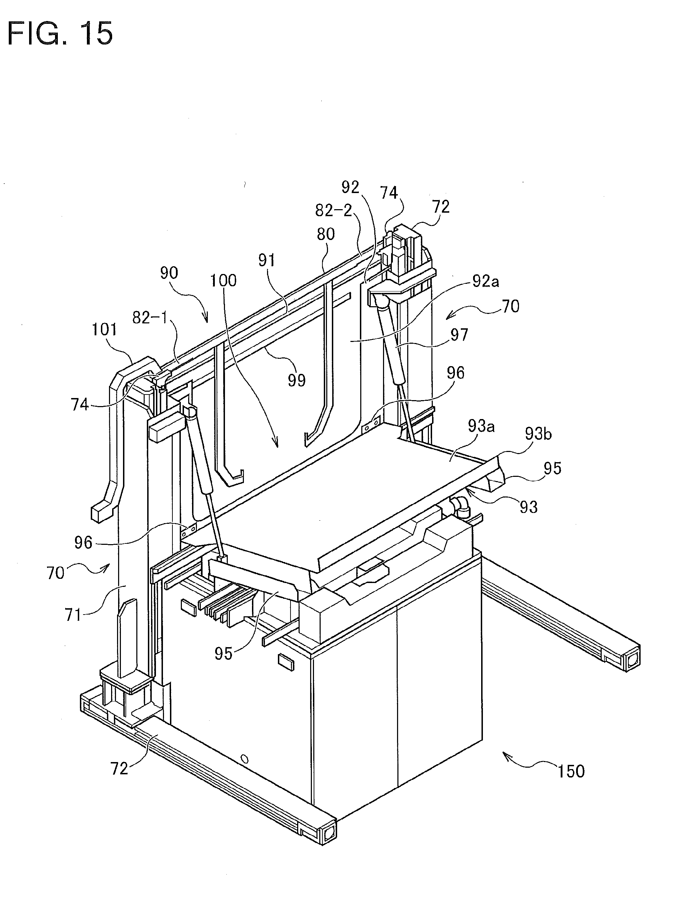

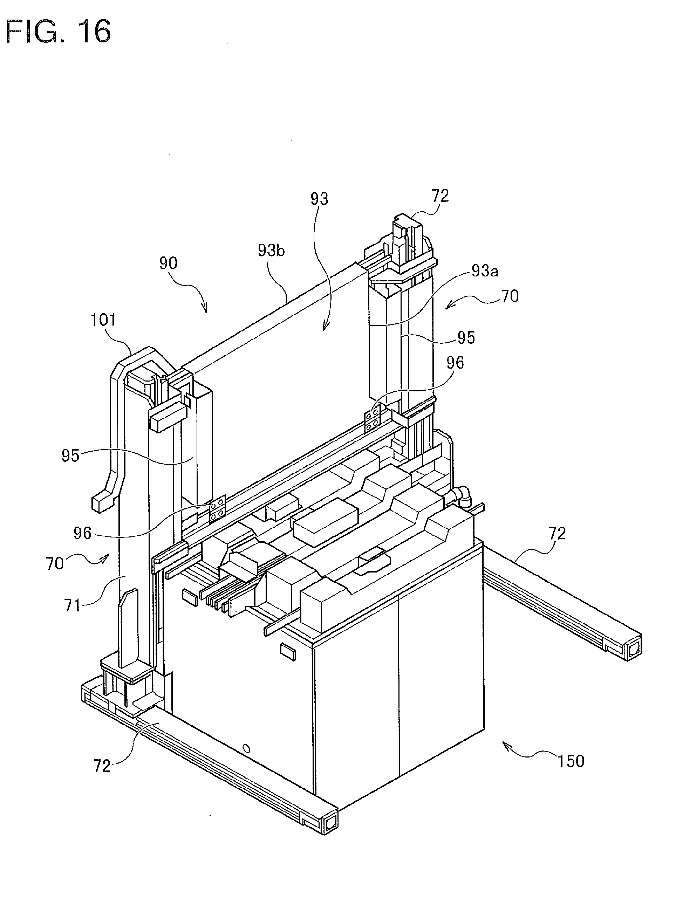

Next, details of the lifters 70 which are respectively provided at the pre-wet baths 115a and 115b, the pre-wet baths 145a and 145b, the etching module 120 and the resist removing module 150 which are shown in FIG. 1 will be described. FIG. 14 is a perspective view showing the lifters 70. In order to describe a positional relation of the lifters 70 and the processing bath, FIG. 14 also shows the etching module 120. While the cover 90 shown in FIGS. 15 and 16 referred to below is provided on the lifter 70 in actuality, the illustration of the cover 90 is omitted in FIG. 14 for description of the lifter 70.

As shown in FIG. 14, the lifters 70 include a pair of rail portions 71 that are disposed at both sides of the etching module 120, slide portions 75 that are slidably provided at the rail portions 71, support portions 74 that are provided at the slide portions 75, and horizontal moving mechanisms 72 that can move the rail portions 71 in the horizontal direction.

The horizontal moving mechanisms 72 are provided along the horizontal direction at both the sides of the etching module 120. The pair of rail portions 71 are provided to extend in the vertical direction from the horizontal moving mechanisms 72, and include rails for the slide portions 75 to slide, at opposing sides of the pair of rail portions 71. The slide portions 75 are configured to be slidable on the rail portions 71 in the vertical direction along the rails of the rail portions 71. Note that the slide portions 75 are slid in the vertical direction by a drive device not illustrated.

The support portions 74 are members formed to protrude at the opposing sides of the pair of the rail portions 71, and support the arm portions 82-1 and 82-2 of the substrate holder 80 from below as illustrated. That is to say, the substrate holder 80 is supported by the support portions 74 to be positioned between the pair of the rail portions 71.

When the lifters 70 receive the substrate holder 80 from the substrate transfer devices 50a or 50b shown in FIG. 1, the grasping mechanism 54 of the substrate transfer device 50a or 50b (see FIGS. 6 to 11)first moves above the lifters 70 while the grasping mechanism 54 grasps the substrate holder 80 horizontally. Subsequently, the grasping mechanism 54 turns, whereby the substrate holder 80 is turned so that the in-plane direction of the substrate W is perpendicularly oriented. The support portions 74 of the lifters 70 slide in the upward direction with the rail portions 71, and support the substrate holder 80 from below. The grasping mechanism 54 releases grasp on the substrate holder 80 in the state in which the support portions 74 support the substrate holder 80, whereby the substrate holder 80 is transferred to the support portions 74. The lifters 70 move the rail portions 71 in the horizontal direction by the horizontal moving mechanisms 72 in accordance with necessity, and position the rail portions 71 at lateral sides of a predetermined processing bath of the etching module 120. Thereby, the substrate holder 80 is disposed directly above the predetermined processing bath. In this state, the support portions 74 slide downward along the rail portions 71, whereby the substrate holder 80 can be stored into the processing bath.

When the lifters 70 transfer the substrate holder 80 to the substrate transfer devices 50a and 50b shown in FIG. 1, the support portions 74 first support the arm portions 82-1 and 82-2 of the substrate holder 80 which is stored in the processing bath of the etching module 120 from below. Subsequently, the support portions 74 rise along the rail portions 71, whereby the substrate holder 80 is taken out from the processing bath. In the state in which the support portions 74 support the substrate holder 80, the lifters 70 move the rail portions 71 horizontally to the predetermined transfer position of the substrate transfer device 50a or 50b by the horizontal moving mechanisms 72, in accordance with necessity. The grasping mechanism 54 of the substrate transfer device 50a or 50b grasps the substrate holder 80, and thereafter the support portions 74 of the lifter 70 lower along the rail portions 71, whereby the substrate holder 80 is transferred to the substrate transfer device 50a or 50b.

### <Cover>

Next, details of the cover 90 shown in FIG. 2 and constructed so as to cover the periphery of the substrate holder 80 supported on the lifter 70 will be described. FIGS. 15 and 16 are perspective views of the lifter 70 with the cover 90, FIG. 5 showing a state where the cover 90 is open, FIG. 16 showing a state where the cover 90 is closed. The resist removing module 150 is also shown in FIGS. 15 and 16 for explanation of the positional relationship between the cover 90 and the processing bath. In the following description, "front side" refers to the side at which the cover 90 is opened and "rear side" refers to the side opposite from the front side.

As shown in FIGS. 15 and 16, the cover 90 is provided with a fixed rear side part 91 generally in plate form formed between a pair of rail portions 71 of the lifter 70, a fixed front side part 92 (corresponding to one example of a fixed part), and a movable cover part 93 turnably attached by hinges 96 to the fixed front side part 92 at the front side of the same. The fixed rear side part 91 and the fixed front side part 92 are attached to the rail portions 71 of the lifter 70 while being spaced apart from each other so that the support portions 74 of the lifter 70 and the substrate holder 80 can pass therebetween. The fixed front side part 92 is a member generally in plate form having an opening 92a at its center.

The movable cover part 93 has a movable side portion 93a for covering the opening 92a from the front side of the fixed front side part 92, and a movable upper portion 93b for covering a gap between the fixed rear side part 91 and the fixed front side part 92 when the movable side portion 93a is closed. A lower end of the movable side portion 93a is attached by the hinges 96 to the fixed front side part 92. The cover 90 is opened and closed by turning the movable cover part 93 on the hinges 96. The cover 90 also has piston cylinder mechanisms 97 (corresponding to one example of a cover drive section) for opening and closing the movable cover part 93. The movable cover part 93 has cylinder covers 95 for covering the piston cylinder mechanisms 97 when the movable cover part 93 is closed. One end of each piston cylinder mechanism 97 is attached to the fixed front side part 92, while the other end is attached to the cylinder cover 95.

The cover 90 has an exhaust mechanism 101 (corresponding to one example of an exhaust section) for exhausting gas from the cover 90. The exhaust mechanism 101 exhausts gas from the cover 90 through an exhaust port 99 provided in the fixed rear side part 91. An opening 100 is formed in a bottom section between the fixed rear side part 91 and the fixed front side part 92 by the fixed rear side part 91 and the fixed front side part 92. Through this opening 100, the substrate holder 80 supported on the lifter 70 is moved into and out of a processing bath, e.g., that of the resist removing module 150 positioned below the cover 90.

As shown in FIG. 16, the cover 90 can cover the periphery of the substrate holder 80 supported on the lifter 70 when the movable cover part 93 is closed. Gas in the space covered with the cover 90 is exhausted by the exhaust mechanism 101.

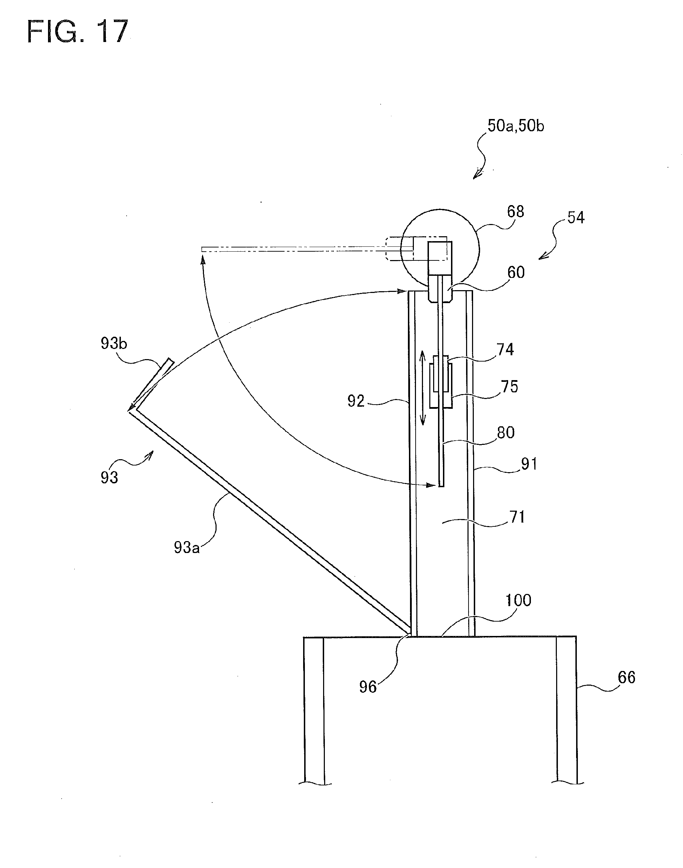

FIG. 17 is a schematic sectional side view of the lifter 70, the substrate transfer devices 50a and 50b, the cover 90 and the processing bath 66 at the time of delivery of the substrate holder 80 between the lifter 70 and the substrate transfer device 50a or 50b. As illustrated, the cover 90 is closed by turning the movable cover part 93 on the hinges 96 provided at the lower end of the movable side portion 93a. Also, with rotation of a rotating shaft 68 of the substrate transfer device 50a or 50b, the substrate holder 80 held by the holder clamps 60 is swung and the direction of the substrate holder 80 is changed between the horizontal direction and the vertical direction. At this time, the cover 90 is opened to such a predetermined angle that it does not obstruct the swing of the substrate holder 80.

The positional relationship between the substrate transfer device 50a or 50b and the cover 90 is set so that the substrate transfer device 50a or 50b and the substrate holder 80 pass over the cover 90 when the transfer mechanism 51 (see FIG. 6) of the substrate transfer device 50a or 50b transfers the substrate holder 80 while the in-plane direction of the substrate W is horizontally orientated.

Next, control of the cover 90 shown in FIGS. 15 to 17 will be described. The cover 90 is normally maintained in the closed state shown in FIG. 16 and is in the open state shown in FIG. 15 when the lifter 70 delivers the substrate holder 80 to the substrate transfer device 50a or 50b or receives the substrate holder 80 from the substrate transfer device 50a or 50b. More specifically, when the lifter 70 receives the substrate holder 80 from the substrate transfer device 50a or 50b, the support portions 74 of the lifter 70 are moved upward along the rail portions 71 and the movable cover part 93 of the cover 90 is opened so that the cover 90 is in the open state shown in FIG. 15. After the lifter 70 receives the substrate holder 80, the support portions 74 are moved downward long the rail portions 71 while the cover 90 is in the closed state, thereby storing the substrate holder 80 in the processing bath through the opening 100.

When the substrate holder 80 is taken out from the processing bath, the arm portions 82-1 and 82-2 of the substrate holder 80 are supported from below by the support portions 74 of the lifter 70 and the support portions 74 are moved upward along the rail portions 71 while the cover 90 is in the closed state. At this time, the periphery of the substrate holder 80 taken out from the processing bath is covered with the cover 90. Therefore a processing solution atmosphere generated, for example, by evaporation of a processing solution attached to the substrate holder 80 and the substrate W is confined in the cover 90. Further, since gas in the cover 90 is exhausted by the exhaust mechanism 101, diffusion out of the cover 90 of the processing solution atmosphere confined in the cover 90 is limited.

The lifter 70 is horizontally moved and the substrate holder 80 is moved, for example, to a position above a cleaning bath for cleaning to remove the processing solution attached to the substrate W, while the cover 90 is maintained in the closed state. The support portions of the lifter 70 above the cleaning bath are moved downward to store the substrate holder 80 in the cleaning bath. The substrate W cleaned and the substrate holder 80 are taken out from the cleaning bath with the lifter 70. When the substrate holder 80 taken out from the cleaning bath is delivered to the substrate transfer device 50a or 50b, the movable cover part 93 of the cover 90 is opened and the support portions 74 of the lifter 70 are moved upward to the position of delivery to the substrate transfer device 50a or 50b. After the substrate holder 80 has been delivered to the substrate transfer device 50a or 50b, the movable cover part 93 of the cover 90 is closed, thereby closing the cover 90 again.

As described above, the substrate processing apparatus 250 according to the present embodiment is provided with the cover 90 constructed so as to cover the periphery of the substrate holder 80 supported on the lifter 70. A processing solution atmosphere generated, for example, by evaporation of a processing solution attached to the substrate holder 80 and the substrate W can thereby be confined in the cover 90 and diffusion of the processing solution atmosphere out of the cover 90 can be inhibited.

The cover 90 has the movable cover part 93 and the piston cylinder mechanisms 97 for opening/closing the cover 90 by driving the movable cover part 93 and can therefore be opened at the time of delivery of the substrate holder 80 to or from the substrate transfer device 50a or 50b. While the piston cylinder mechanisms 97 are provided as means for driving the movable cover part 93 in the present embodiment, the means for driving the movable cover part 93 is not limited to the piston cylinder mechanisms 97. Some other drive mechanism may alternatively be used.

The piston cylinder mechanisms 97 drive the movable cover part 93 to open the cover 90 when the substrate transfer device 50a or 50b delivers the substrate holder 80 to the lifter 70 or receives the substrate holder 80 from the substrate transfer device 50a or 50b. In other words, the piston cylinder mechanisms 97 maintain the cover 90 in the closed state when the substrate transfer device 50a or 50b does not deliver the substrate holder 80 to the lifter 70 or receive the substrate holder 80 from the substrate transfer device 50a or 50b. The time period during which the cover 90 is open can thus be minimized and diffusion of the processing solution atmosphere out of the cover 90 can be inhibited.

The cover 90 also has the fixed front side part 92 to which one end of the movable cover part 93 is fixed, and the hinges 96 by which the one end of the movable cover part is turnably fixed to the fixed front side part 92. The piston cylinder mechanisms 97 opens and closes the cover 90 by turning the movable cover part 93 on the hinges 96. The cover 90 can thereby be opened and closed so as not to obstruct delivery of the cover 90 when the substrate transfer device 50a or 50b delivers the substrate holder 80 to the lifter 70 or receives the substrate holder 80 from the substrate transfer device 50a or 50b. The arrangement in which the movable cover part 93 is fixed by the hinges' 96 to the fixed front side part 92 according to the present embodiment is not exclusively used. The movable cover part 93 may be attached, for example, to the lifter 70 or a different fixed part capable of being horizontally moved together with the lifter 70.

The holder clamps 60 of the grasping mechanism 54 (see FIG. 6) grasps the substrate holder 80 while the in-plane direction of the substrate W is horizontally oriented, and the transfer mechanism (see FIG. 6) transfers the substrate holder 80 so that the substrate holder 80 passes over the cover 90 while the in-plane direction of the substrate W is horizontally oriented. Therefore, even while the lifter 70 is putting the substrate holder 80 in the processing bath 66 or taking the substrate holder 80 out of the processing bath 66, the substrate transfer device 50a or 50b can transfer another substrate holder 80 by passing the substrate holder 80 over the cover 90. Accordingly, even while the lifter 70 is putting the substrate holder 80 in the processing bath 66 or taking the substrate holder 80 out of the processing bath 66, there is no need to wait for transfer of another substrate holder 80 by the substrate transfer device 50a or 50b. The throughput of the substrate processing apparatus 250 can therefore be improved. That is, for example, an operation to put the substrate holder 80 in the processing bath 66 or take the substrate holder 80 out of the processing bath 66 with the lifter 70 on one etching module 120 and an operation to transfer another substrate holder 80 to another etching module 120 or to retrieve another substrate holder 80 from another etching module 120 with the substrate transfer device 50a or 50b above the lifter 70 can be performed independently of each other without waiting in one of the two operations for the other.

The cover 90 is positioned above the processing bath 66. Also, the cover 90 has in its bottom section the opening 100 through which the substrate holder 80 is stored in the processing bath 66 located below the cover 90 or taken out from the processing bath 66. Therefore, the substrate holder 80 covered with the cover 90 can easily be put in or taken out from the processing bath 66.

Since the substrate processing apparatus 250 has the exhaust mechanism 101 for exhausting gas from the interior of the cover 90, diffusion out of the cover 90 of the processing solution atmosphere confined in the cover 90 can be inhibited.

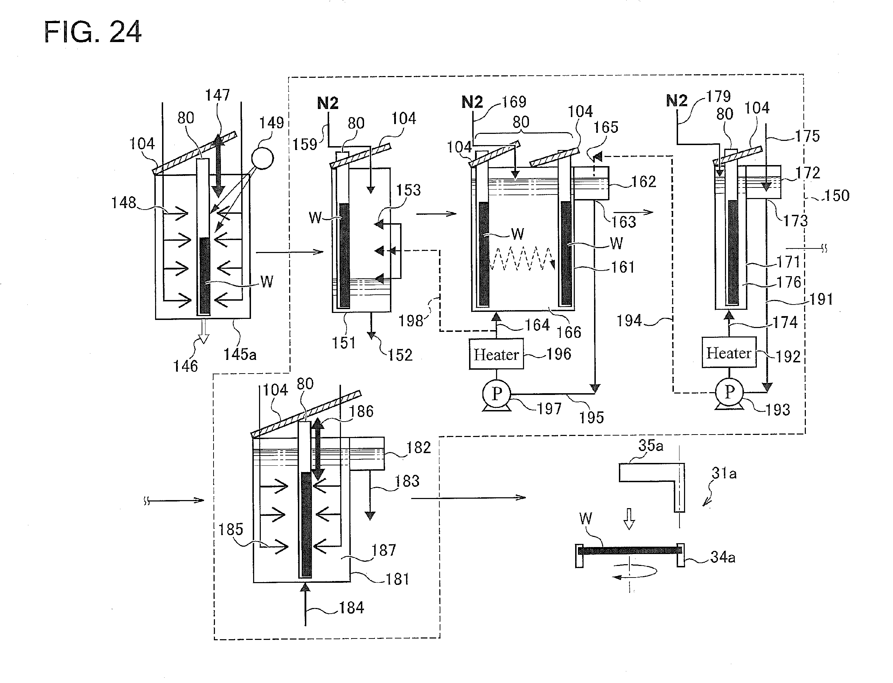

The cover 90 is horizontally moved together with the lifter 70. Accordingly, the cover 90 covers the periphery of the substrate holder 80 each time the substrate holder 80 is transferred between adjacent two of the processing baths in the process, for example, from immersion of the substrate holder 80 in a first stripping bath 151 (see FIG. 24) in a resist removing module 150 to final cleaning in a rinse bath 181 (see FIG. 24), thus enabling confinement of the processing solution atmosphere in the cover 90 until the processing solution attached to the substrate holder 80 and the substrate W.

### <Processing bath>

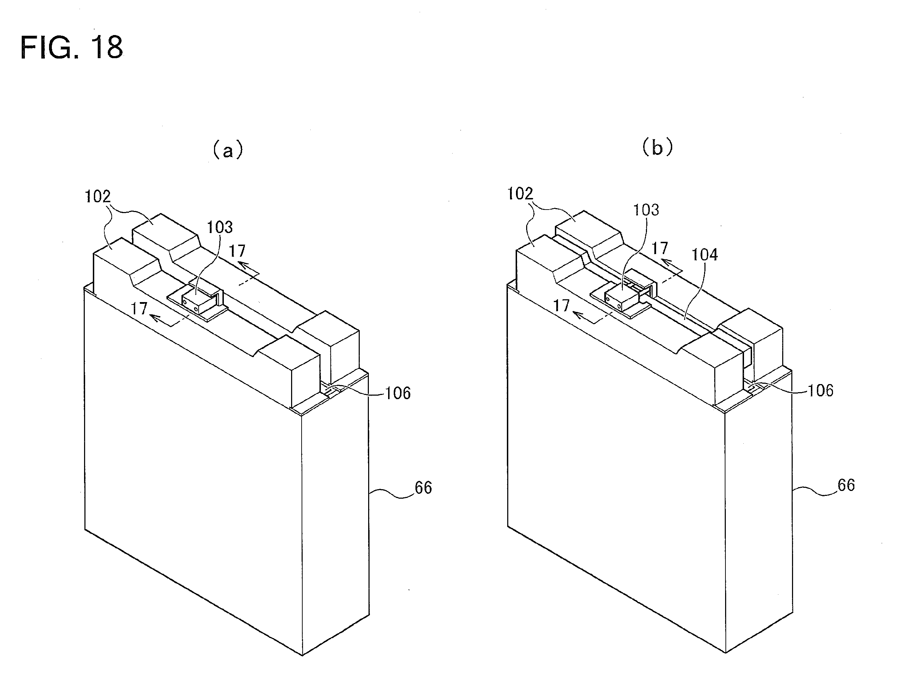

Next, the processing bath constituting the etching module 120 or the resist removing module 150 will be described. FIGS. 18A and 18B are schematic perspective views of the processing bath 66 in which one or two substrate holders 80 are stored, FIG. 18A showing a state where a shutter is open, FIG. 18B showing a state where the shutter is closed. As shown in FIGS. 18A and 18B, the processing bath 66 has in its upper portion an opening 106 through which the substrate holder 80 is put in or taken out. A lid part 102 which partially covers the opening 106 is provided on the opening 106. The lid part 102 has a shutter 104 capable of opening and closing the portion of the opening 106 not covered with the lid part 102, and an air cylinder 103 for opening and closing the shutter 104. The processing bath 66 is also provided with an exhaust device not illustrated. The exhaust device exhausts gas from the interior of the processing bath 66 covered with the lid part 102 and the shutter 104.

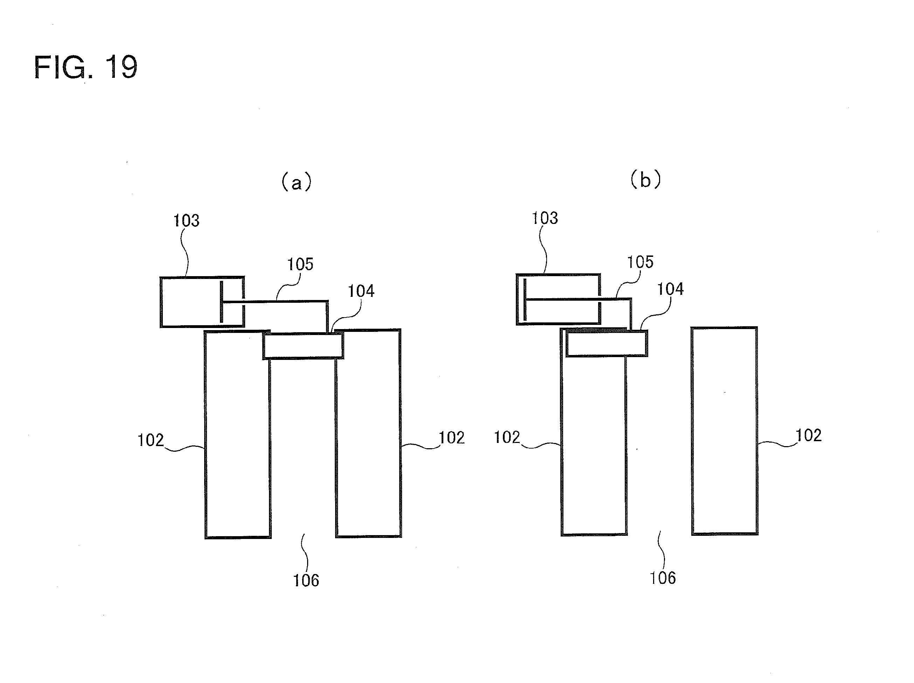

FIGS. 19A and 19B are schematic sectional views of the lid part 102 taken along line 17-17 in FIGS. 18A and 18B, FIG. 19A showing a state where the shutter 104 is closed, FIG. 19B showing a state where the shutter 104 is open. As shown in FIGS. 19A and 19B, the air cylinder 103 has a piston 105 connected to the shutter 104. The air cylinder 103 opens and closes the shutter 104 by extending and retracting the piston 105. The shutter 104 is partially housed in the lid part 102.

When the lifter 70 (see FIG. 14) stores the substrate holder 80 in the processing bath 66, the shutter 104 is first opened. The lifter 70 moves the substrate holder 80 downward to store the substrate holder 80 in the processing bath 66. The shutter 104 is thereafter closed.

When the lifter 70 takes out the substrate holder 80 from the processing bath 66, the shutter 104 is first opened. The lifter 70 moves the substrate holder 80 upward to take out the substrate holder 80 from the processing bath 66. The shutter 104 is thereafter closed.

The processing bath 66 has the shutter 104 capable of opening and closing the opening 106 of the processing bath 66, as shown in FIGS. 18 and 19. Therefore, diffusion of a processing solution atmosphere generated, for example, by evaporation of a processing solution contained in the processing bath 66 can be inhibited by closing the shutter 104 when the operation to put the substrate holder 80 in the processing bath 66 or take out the substrate holder 80 from the processing bath 66 is not performed. In particular, if the processing bath 66 is a bath for processing the substrate W by using an organic solvent, diffusion of a chemical solution atmosphere generated from the organic solvent can be inhibited.

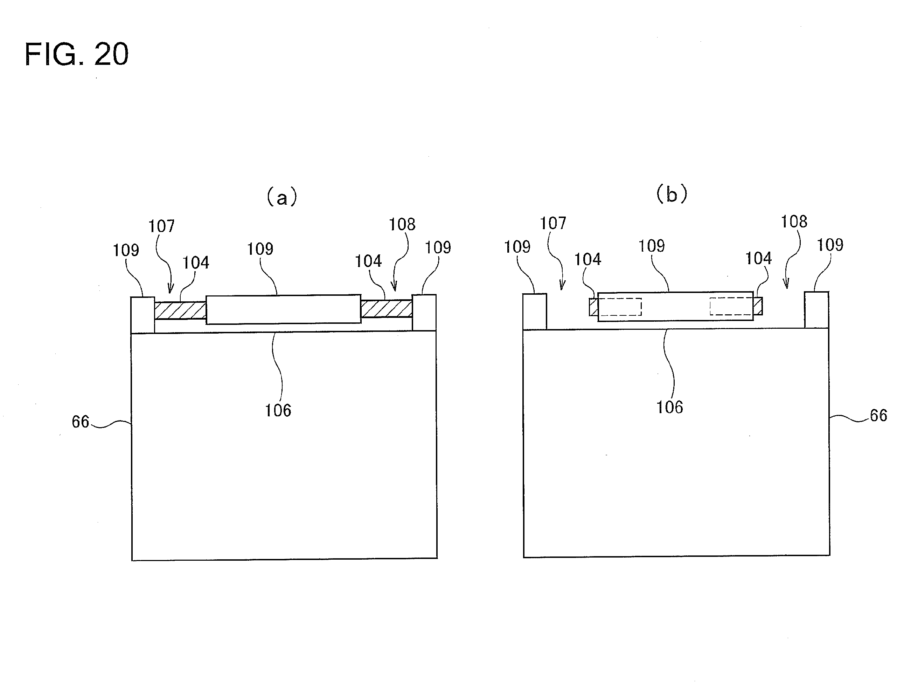

FIGS. 20A and 20B are schematic side views of the processing bath 66 storing a plurality of substrate holders 80, FIG. 20A showing a case where the shutter is closed, FIG. 20B showing a case where the shutter is open. As shown in FIGS. 20A and 20B, the processing bath 66 has in its upper portion an opening 106 through which the substrate holder 80 is put in or taken out. A lid part 109 which partially covers the opening 106 is provided on the opening 106. The lid part 109 has an inlet opening portion 107 for storing the substrate holder 80 through the opening 106, an outlet opening portion 108 for taking out the substrate holder 80 from the opening 106, and two shutters 104 for opening and closing the inlet opening portion 107 and the outlet opening portion 108.

The lid part 109 positioned at a center of the opening 106 is fixed on the processing bath 66 by fixing means not illustrated so that a predetermined spacing is provided between the lid part 109 and upper edge portions of the processing bath 66. The arm portions 82-1 and 82-2 (see FIG. 3) of the substrate holder 80 can pass through this spacing. The processing bath 66 is also provided with an exhaust device not shown. The exhaust device exhausts gas from the interior of the processing bath 66 covered with the lid part 109 and the shutter 104. Opening/closing of the shutter 104 is performed, for example, by drive means similar to the air cylinders 103 shown in FIGS. 19A and 19B. The shutter on the inlet opening portion 107 and the shutter 104 on the outlet opening portion 108 can be opened and closed independently of each other.

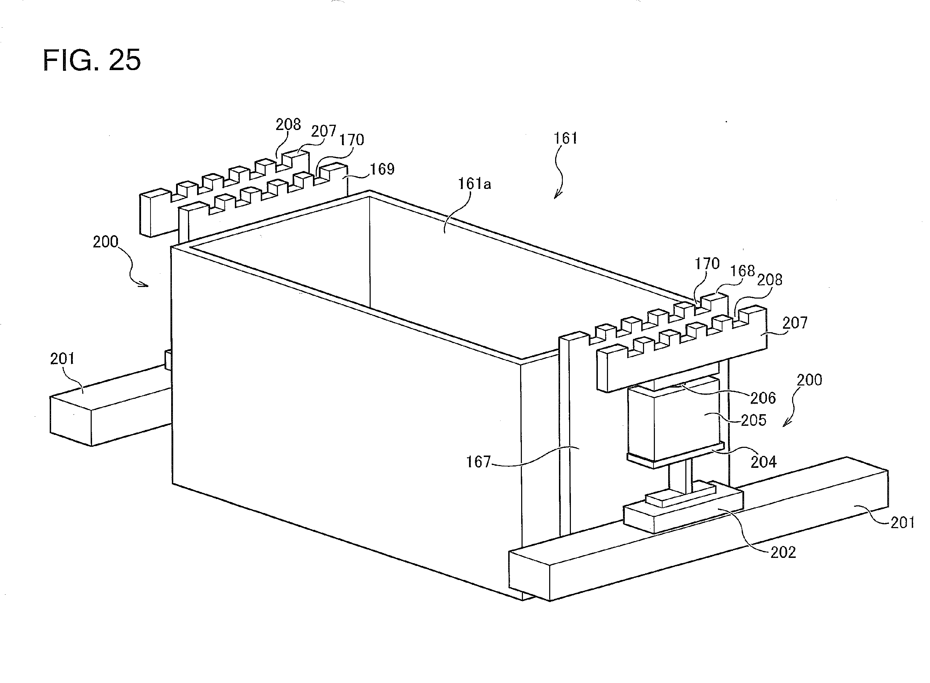

When the lifter 70 (see FIG. 14) stores the substrate holder 80 in the processing bath 66, the lifter 70 supporting the substrate holder 80 first moves to a position right above the inlet opening portion 107. Subsequently, the shutter on the inlet opening portion 107 is opened. The lifter 70 moves the substrate holder 80 downward to store the substrate holder 80 in the processing bath 66 through the inlet opening portion 107. The shutter 104 on the inlet opening portion 107 is thereafter closed. The substrate holder 80 stored in the processing bath 66 from the inlet opening portion 107 is moved to the outlet opening portion 108 side through the interior of the processing bath 66 by a substrate holder shifting mechanism 200 described later (see FIG. 25).

When the lifter 70 takes out the substrate holder 80 from the processing bath 66, the lifter 70 first moves to a position right above the outlet opening portion 108. Subsequently, the shutter on the outlet opening portion 108 is opened. The lifter 70 moves the substrate holder 80 upward to take out the substrate holder 80 from the processing bath 66. The shutter 104 on the outlet opening portion 108 is thereafter closed.

The processing bath 66 has the lid part 109 that covers the opening 106, as shown in FIGS. 20A and 20B. The lid part 109 has the inlet opening portion 107, the outlet opening portion 108 for taking out the substrate holder 80 from the opening 106, and the shutters 104 for opening and closing these opening portions. In the processing bath 66 in which processing is performed on a plurality of substrate holders, therefore, diffusion of a processing solution atmosphere generated, for example, by evaporation of a processing solution contained in the processing bath 66 can be inhibited by closing the shutter 104 when the operation to put the substrate holder 80 in the processing bath 66 or take out the substrate holder 80 from the processing bath 66 is not performed. In particular, if the processing bath 66 is a bath for processing the substrate W by using an organic solvent, diffusion of a chemical solution atmosphere generated from the organic solvent can be inhibited.

Since the shutter 104 on the inlet opening portion 107 and the shutter 104 on the outlet opening portion 108 are constructed so as to be openable and closable independently of each other, only the shutter 104 on the inlet opening portion 107 can be opened when the substrate holder 80 is stored in the processing bath 66, and only the shutter 104 on the outlet opening portion 108 can be opened when the substrate holder 80 is taken out from the processing bath 66. The time period during which the inlet opening portion 107 is open and the time period during which the outlet opening portion 108 is open can therefore be minimized to further inhibit diffusion of the chemical solution atmosphere.

### <Etching unit>

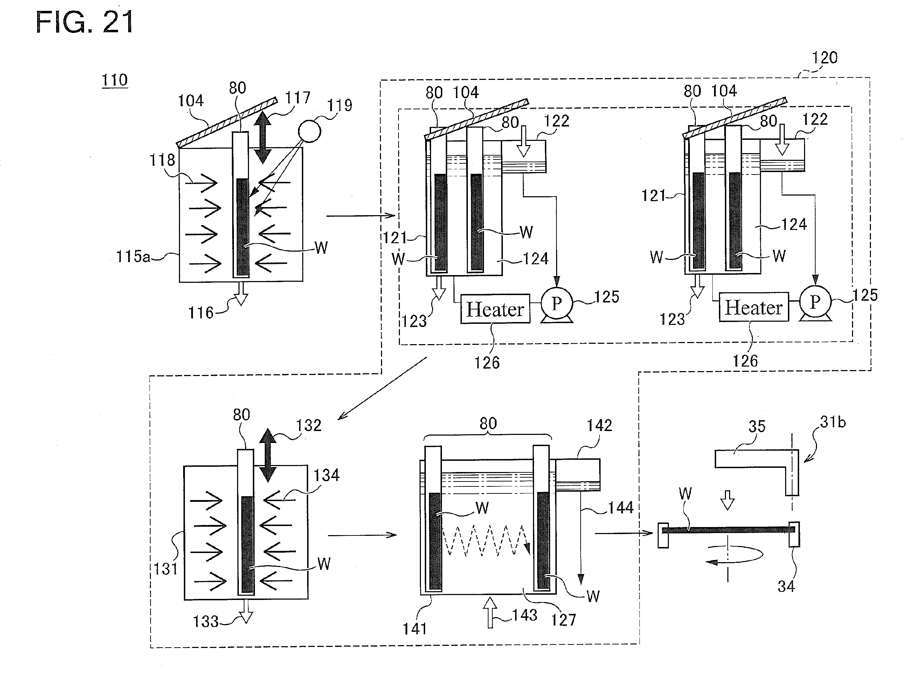

The construction of the etching unit 110 will be concretely described. FIG. 21 is a schematic diagram showing processing baths constituting the etching unit 110. In FIG. 21, the substrate dryer 31b shown in FIG. 1 is also shown for convenience sake. The etching unit 110 is provided with two pre-wet bath 115a and 115b for enhancing the hydrophilicity of the substrate W surface (only pre-wet bath 115a being shown in FIG. 21), and three etching modules 120 (only one etching module 120 being shown in FIG. 21). The etching module 120 is provided with two etching baths 121 for etching the seed layer in the substrate W surface, a first rinse bath 131 for performing first cleaning on the substrate W having the seed layer etched, and a second rinse bath 141 for performing second cleaning on the substrate W cleaned in the first rinse bath 131.

The pre-wet bath 115a is a processing bath in which a single substrate holder 80 can be stored. The pre-wet bath 115a has a DIW sprinkling portion 118 for sprinkling DIW to the substrate W, an IPA sprinkling portion 119 for sprinkling IPA to the substrate W, a discharge port 116 through which DIW and IPA sprinkled to the substrate W are discharged out of the bath, and a to-and-fro movement mechanism 117 for moving the substrate holder 80 to and fro in the vertical direction. The pre-wet bath 115a also has a shutter for opening and closing the opening of the pre-wet bath 115a, which is the shutter 104 shown in FIGS. 18 and 19.

While the substrate W stored in the pre-wet bath 115a is being moved to and fro in the vertical direction together with the substrate holder 80, DIW is sprinkled from the DIW sprinkling portion 118 to the substrate W. Heated DIW may be used instead of DIW at ordinary temperature. To enhance the hydrophilicity of the substrate W surface, DIW or heated DIW may be sprinkled from the DIW sprinkling portion 118 after sprinkling of IPA from the IPA sprinkling portion 119. The shutter 104 is closed during time periods other than a time period in which the substrate holder 80 is put in the pre-wet bath 115a and a time period in which the substrate holder 80 is taken out from the pre-wet bath 115a. Diffusion of an IPA atmosphere generated by evaporation of IPA can thereby be inhibited. Also, DIW and IPA are sprinkled to the entire substrate W surface as a result of moving the substrate W to and fro in the vertical direction with the to-and-fro movement mechanism 117. A further improvement in hydrophilicity of the substrate W surface can thereby be achieved. Description of the pre-wet bath 115b shown in FIG. 1 is omitted because the pre-wet bath 115b is identical in construction to the pre-wet bath 115a.

Each of the two etching baths 121 is a bath capable of containing a processing solution 124 such as a sulfuric acid/hydrogen peroxide mixture (SPM) and performing etching processing on two substrates W at a time. The etching bath 121 is provided with an outside bath 122 which receives the processing solution 124 overflowing from the etching bath 121, a heater 126 which heats the processing solution 124 from the outside bath 122, a pump 125 which transports the processing solution 124 from the outside bath 122 to the heater 126, a discharge port 123 for discharging out of the etching bath 121 the processing solution 124 contained in the etching bath 121, and a shutter for opening and closing the opening of the etching bath 121, which is the shutter 104 shown in FIGS. 18 and 19. Not only the processing solution 124 overflowing from the etching bath 121 but also unused processing solution 124 from a different passage are led into the outside bath 122. The amount of unused processing solution 124 corresponding to the processing solution 124 discharged through the discharge port 123 is supplied to the outside bath 122.

The substrate W having a Cu seed layer formed in its surface undergoes pre-wet processing in the pre-wet baths 115a and 115b and is thereafter stored in the etching bath 121. The substrate W is immersed in the processing solution 124 for a predetermined time period (e.g., several ten seconds) to etch the Cu seed layer. The processing solution 124 increased in temperature by the heater 126 is led into the etching bath 121 by the pump 125 at a constant flow rate (e.g., 10 L/min). Simultaneously, the processing solution 124 in the etching bath 121 overflows and flows into the outside bath 122. That is, the processing solution 124 is circulated among the etching bath 121, the outside bath 122 and the heater 126 so as to be maintained in a certain temperature range. The shutter 104 is closed during time periods other than a time period in which the substrate holder 80 is put in the etching bath 121 and a time period in which the substrate holder 80 is taken out from the etching bath 121. Diffusion of the processing solution atmosphere can therefore be inhibited by discharging the atmosphere around the etching bath 121 and the outside bath 122 with the exhaust device not illustrated. Either one of the two etching baths 121 may be selectively used. The two etching baths 121 may be used continuously. The process may alternatively be such that the two etching baths are continuously used, with cleaning in the first rinse bath 131 interposed between the processings in the two etching baths.

The first rinse bath 131 is a processing bath in which a single substrate holder is stored, and in which the substrate W etched in the etching bath 121 is cleaned. The first rinse bath 131 has a DIW sprinkling portion 134 for sprinkling DIW to the substrate W, a discharge port 133 through which DIW sprinkled to the substrate W is discharged out of the bath, and a to-and-fro movement mechanism 132 for moving the substrate holder 80 to and fro in the vertical direction.

While the substrate W stored in the first rinse bath 131 is being moved to and fro in the vertical direction together with the substrate holder 80, DIW is sprinkled from the DIW sprinkling portion 134 to the substrate W. The processing solution attached to the substrate W surface is thereby washed off. Also, DIW is sprinkled to the entire substrate W surface as a result of moving the substrate W to and fro in the vertical direction with the to-and-fro movement mechanism 132, thus enabling the entire substrate W surface to be cleaned with efficiency.

The second rinse bath 141 is a bath in which a plurality of substrate holders are stored, and in which the substrate W cleaned in the first rinse bath 131 is further cleaned. The interior of the second rinse bath 141 is filled with DIW 127 and a plurality of substrate holders 80 is immersed in this DIW 127 for a predetermined time period to be cleaned. The second rinse bath 141 has an outside bath 142 which receives DIW 127 overflowing from the second rinse bath 141, a discharge port 142 which is provided in the outside bath 142, and through which DIW in the outside bath 142 is discharged, and a supply port 143 through which unused DIW 127 is supplied into the second rinse bath 141.

While the substrate holders 80 are immersed in DIW 127, unused DIW 127 is supplied from the supply port 143 at a constant flow rate. Simultaneously, DIW 127 in the second rinse bath 141 overflows from the second rinse bath 141 and flows into the outside bath 142. The DIW 127 having flowed into the outside bath 142 is discharged through the discharge port 144.

The substrate dryer 31b has a turntable 34 which supports the substrate W cleaned in the second rinse bath 141 and rotates the substrate W along its circumferential direction, and a nozzle 35 from which DIW and vapor of IPA are supplied to the substrate W supported on the turntable 34.

The substrate W is supported and rotated at a predetermined speed by the turntable 34. Through the nozzle 35, each of DIW and vapor of IPA containing nitrogen is individually supplied to the substrate W surface. That is, the nozzle 35 is constituted by a nozzle for supplying DIW and a nozzle for supplying vapor of IPA. Supply orifices of the nozzle are moved to and fro from the center of the substrate W in a radial outward direction while DIW and vapor of IPA are being supplied. Uniform water film is thereby formed in the substrate W plane. Simultaneously, the water film is moved radially outward on the substrate W by centrifugal force and a force (Marangoni force) produced due to a surface tension gradient (difference) between IPA and DIW, thereby drying the substrate W surface.

Transfer of the substrate holder 80 among the etching bath 121, the first rinse bath 131 and the second rinse bath 141 is performed with the lifter 70 shown in FIGS. 14 to 16. Operations performed by the substrate transfer device 50b on the etching module 120 are delivering the substrate holder 80 holding an unprocessed substrate to the lifter standing by at one of the etching baths 121 and receiving the substrate holder 80 holding the processed substrate from the lifter 70 positioned on the second rinse bath 141 at the position for lifting up the substrate holder 80. Transfer of the substrate holder 80 between the pre-wet bath 115a and the resist removing module 150 is performed by the substrate transfer device 50b shown in FIG. 6 and other figures.

The present invention has been described by assuming that the substrate processing apparatus 250 has the etching bath 121 for etching the Cu seed layer. However, the present invention is not limited to this. For example, an oxide film removal bath for removing oxide film on the substrate W surface or a barrier layer removal bath for removing a barrier layer such as Ti on the substrate W surface may be adopted in place of the etching bath 121. In a case where an oxide film removal bath or a barrier layer removal bath, DHF (dilute fluoric acid) for example is used as processing solution 124 and the bath arrangement may be the same as that of the etching bath 121 in other respects. Since DHF is a volatile chemical solution, the shutter 104 shown in FIGS. 18 and 19 and other figures may be provided on the oxide film removal bath or the barrier layer removal bath.

The present embodiment has been described by assuming that the to-and-fro movement mechanism for moving the substrate holder 80 to and fro in the vertical direction in the bath is provided on each of the pre-wet baths 115a and 115b and the first rinse bath 131. However, the present invention is not limited to this. The to-and-fro movement mechanism may also be provided on the etching bath 121 and the second rinse bath 141. In such a case, to-and-fro movement of the substrate W causes a flow of processing solution 124 or DIW 145 on the substrate W and also agitates the processing solution 124 or DIW 127, such that the efficiency of etching processing or cleaning processing can be improved.

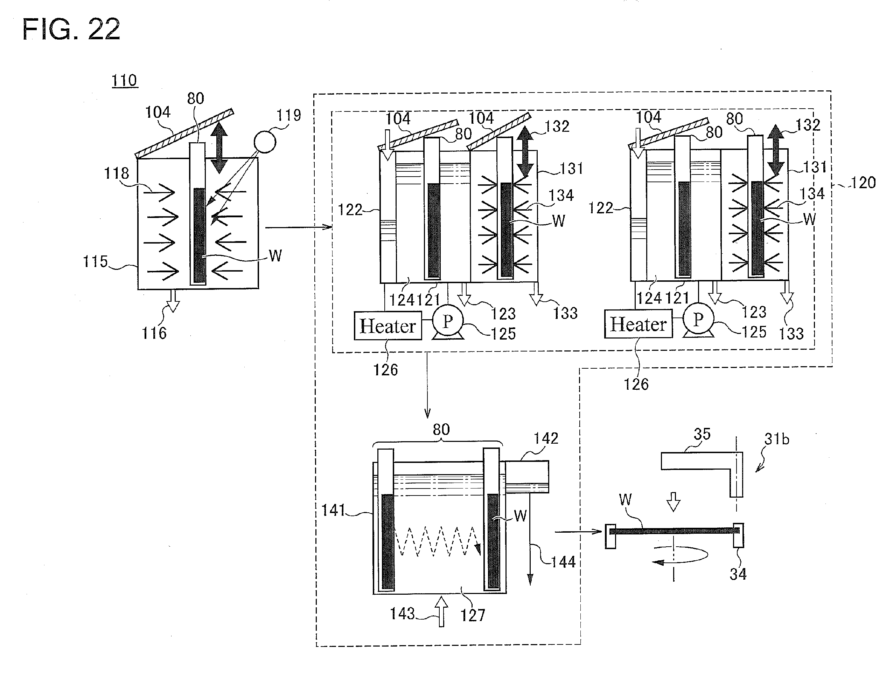

FIG. 22 is a schematic diagram showing another example of processing baths constituting the etching unit 110. In FIG. 22, the substrate dryer 31b shown in FIG. 1 is also shown for convenience sake. The arrangement of the etching unit 110 shown in FIG. 22 differs from that of the etching unit 110 shown in FIG. 21 in the constructions of the etching bath 121 and the first rinse bath 131. The constructions of the other baths in the etching unit 110 shown in FIG. 22 are the same as those in the etching unit 110 shown in FIG. 21. Only the constructions of the etching baths 121 and the first rinse bath 131 will therefore be described while description of the constructions of the other baths is omitted.

The etching bath 121 differs from the etching bath 121 shown in FIG. 21 in being arranged to process one substrate W. Also, two first rinse baths 131 are provided and each first rinse bath 131 is disposed adjacent to one etching bath 121. That is, one first rinse bath 131 is provided integrally with one etching bath 121.

The substrate W etched in one etching bath 121 is transferred to and cleaned in the adjacent first rinse bath 131. The substrate W cleaned in the first rinse bath 131 is transferred to and cleaned in the second rinse bath 141. The substrate W is thereafter dried by the substrate dryer 31b.

Transfer of the substrate holder 80 among the etching bath 121, the first rinse bath 131 and the second rinse bath 141 is performed with the lifter 70 shown in FIGS. 14 to 16. Transfer of the substrate holder 80 between the pre-wet bath 115a and the etching module 120 is performed by the substrate transfer devices 50a and 50b shown in FIG. 6 and other figures.

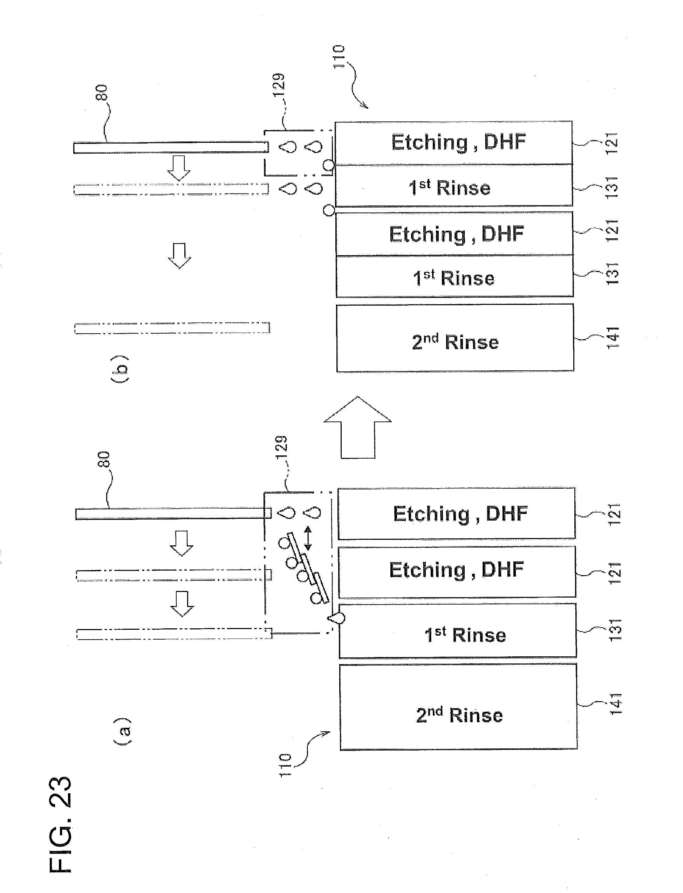

FIGS. 23A and 23B are diagrams showing comparison between the etching unit 110 shown in FIG. 21 and the etching unit 110 shown in FIG. 22, FIG. 23A showing the etching unit 110 shown in FIG. 21, FIG. 23B showing the etching unit 110 shown in FIG. 22. As shown in FIG. 23A, the two etching baths 121 and the first rinse bath 131 are disposed separately one from another in the etching unit 110 shown in FIG. 21. Therefore, the processing solution attached to the substrate holder 80 taken out from one of the etching baths 121 falls as a droplet during transfer of the substrate holder 80 to the first rinse bath 131 with the lifter 70 (omitted in the diagram) shown in FIGS. 14 to 16. That is, a region 129 where the processing solution may fall extends through a wide range from the etching unit 110 to the first rinse bath 131.

On the other hand, as shown in FIG. 23B, the etching baths 121 and the first rinse baths 131 are disposed adjacent to each other one from another in the etching unit 110 shown in FIG. 22. That is, one first rinse bath 131 is provided integrally with one etching bath 121. Therefore, the region 129 where the processing solution on the substrate holder 80 taken out from the etching bath 121 may fall during transfer of the substrate holder 80 to the first rinse bath 131 with the lifter 70 (omitted in the diagram) shown in FIGS. 14 to 16 is reduced relative to that in the etching unit 110 shown in FIG. 21.

As described above, the etching bath 121 and the first rinse bath 131 are disposed adjacent to each other in the etching unit 110 shown in FIG. 22 and, therefore, the range of scatter of a sulfuric acid/hydrogen peroxide mixture or DHF provided as a processing solution is reduced. Diffusion of the processing solution atmosphere due to the scattered processing solution can thereby be inhibited.

### <Resist removing unit>

The construction of the resist removing unit 140 will be concretely described. FIG. 24 is a schematic diagram showing processing baths constituting the resist removing unit 140. In FIG. 24, the substrate dryer 31a shown in FIG. 1 is also shown for convenience sake.

The resist removing unit 140 is provided with two pre-wet baths 145a and 145b (only pre-wet bath 145a being shown in FIG. 24) for enhancing the hydrophilicity of the substrate W surface and three resist removing modules 150 (only one resist removing module 150 being shown in FIG. 24). Each resist removing module 150 is provided with a first stripping bath 151 (corresponding to an example of a first resist separating bath), a second stripping bath 161 (corresponding to an example of a second resist separating bath), a third stripping bath 171 (corresponding to an example of a third resist separating bath), first piping 198 which connects the first stripping bath 151 and the second stripping bath 161 to each other, second piping 194 which connects the second stripping bath 161 and the third stripping bath 171, and the rinse bath 181 in which the substrate W is cleaned after removal of the resist from the substrate W.

The pre-wet bath 145a is a bath in which one substrate holder 80 can be stored so that the in-plane direction of the substrate is vertically oriented. The pre-wet bath 145a has DIW sprinkling portions 148 for sprinkling DIW to the substrate W from opposite sides, an IPA sprinkling portion 149 for sprinkling IPA to the substrate W, a discharge port 146 through which DIW and IPA sprinkled to the substrate W are discharged out of the bath, and a to-and-fro movement mechanism 147 for moving the substrate holder 80 to and fro in the vertical direction. The pre-wet bath 145a also has a shutter for opening and closing the opening of the pre-wet bath 145a, which is the shutter 104 shown in FIGS. 18 and 19.

While the substrate W stored in the pre-wet bath 145a is being moved to and fro in the vertical direction together with the substrate holder 80, DIW is sprinkled from the DIW sprinkling portions 148 to the substrate W. Heated DIW may be used instead of DIW at ordinary temperature. To enhance the hydrophilicity of the substrate W surface, DIW or heated DIW may be sprinkled from the DIW sprinkling portion 148 after sprinkling of IPA from the IPA sprinkling portion 149. The shutter 104 is closed during time periods other than a time period in which the substrate holder 80 is put in the pre-wet bath 145a and a time period in which the substrate holder 80 is taken out from the pre-wet bath 145a. Diffusion of an IPA atmosphere generated by evaporation of IPA can thereby be inhibited. Also, DIW and IPA are sprinkled to the entire substrate W surface as a result of moving the substrate W to and fro in the vertical direction with the to-and-fro movement mechanism 147. A further improvement in hydrophilicity of the substrate W surface can thereby be achieved. Description of the pre-wet bath 145b shown in FIG. 1 is omitted because the pre-wet bath 145b is identical in construction to the pre-wet bath 145a.

The first stripping bath 151 is a bath in which one substrate holder 80 can be stored so that the in-plane direction of the substrate is vertically oriented. The first stripping bath 151 has a sprinkling mechanism 153 for sprinkling a processing solution such as an organic solvent to the substrate W, an exhaust port 152 through which the sprinkled processing solution is discharged out of the bath, a shutter for opening and closing the opening of the first stripping bath 151, which is the shutter 104 shown in FIGS. 18 and 19, and a nitrogen supply port 159 through which nitrogen is supplied into the bath. The sprinkling mechanism 153 communicates with the first piping 198 and the processing solution used in the second stripping bath 161 is transported to the sprinkling mechanism 153 by a first pump 197 described below. That is, the processing solution sprinkled from the sprinkling mechanism 153 is the processing solution used in the second stripping bath 161.

The substrate W having the resist formed on its surface undergoes pre-wet processing in the pre-wet processing in the pre-wet bath 145b and is thereafter stored in the first stripping bath 151. The resist is partially removed by sprinkling the processing solution to the substrate W. The shutter 104 is closed during time periods other than a time period in which the substrate holder 80 is put in the first stripping bath 151 and a time period in which the substrate holder 80 is taken out from the first stripping bath 151. Diffusion of the processing solution atmosphere generated by evaporation of the processing solution, e.g., an organic solvent can therefore be inhibited.

The second stripping bath 161 is a bath in which a processing solution 166 such as an organic solvent is contained and, simultaneously, one substrate holder 80 can be stored so that the in-plane direction of the substrate is vertically oriented. The second stripping bath 161 is provided with an outside bath 162 which receives the processing solution 166 overflowing from the second stripping bath 161, a heater 196 which heats the processing solution 166 from the outside bath 162, the first pump 197 (corresponding to an example of a first transport mechanism) which transports the processing solution 166 from the outside bath 162 to the heater 196, a supply port 164 through which the processing solution 166 heated by the heater 196 is supplied into the second stripping bath 161, shutters for opening and closing the openings of the second stripping bath 161 and the outside bath 162, which are the shutters 104 shown in FIG. 20, and a nitrogen supply port 169 through which nitrogen is supplied into the bath.

The outside bath 162 has a supply port 165 for supplying into the outside bath 162 the processing solution transported from the second piping 194. The outside bath 162 also has a discharge port 163 through which the processing solution in the outside bath 162 is discharged. Piping 195 communicating with the first pump 197 is connected to the discharge port 163. That is, the processing solution supplied to the outside bath 162 is the processing solution used in the third processing bath. This processing solution is supplied to the second stripping bath 161 through the supply port 164 via the discharge port 163, the piping 195, the first pump 197 and the heater 196. The first piping 198 communicates with the heater 196. Therefore, part of the processing solution from the outside bath 162 transported by the first pump 197 is transported to the sprinkling mechanism 153 of the first stripping bath 151 through the heater 196. The amount of the processing solution corresponding to the processing solution transported to the first stripping bath 151 by the first pump 197 is transported from the second piping 194 to the outside bath 162.

When the substrate W is processed in the second stripping bath 161, the substrate holder 80 holding the substrate W is stored in the second stripping bath 161 through the inlet opening portion 107 shown in FIG. 20 with the lifter 70 (see FIG. 14) having the cover 90 (see FIGS. 15 and 16). The stored substrate holder 80 is shifted in the second stripping bath 161 toward the outlet opening portion 108 side shown in FIG. 20 with the substrate holder shifting mechanism 200 described later (see FIG. 25) by taking a predetermine time. The substrate W held by the substrate holder 80 undergoes resist removing processing for the predetermined time period during shifting to the outlet opening portion 108. The substrate holder 80 moved to a position right below the outlet opening portion 108 is taken out through the outlet opening portion 108 with the lifter 70 (see FIG. 14) and transferred to the third stripping bath 171.

While the resist on the substrate W is being removed in the second stripping bath 161, the first pump 197 continues supplying the processing solution 166 from the outside bath 162 to the second stripping bath 161 and to the sprinkling mechanism 153 of the first stripping bath 151. Accordingly, the processing solution 166 in the second stripping bath 161 circulates through the second stripping bath 161, the outside bath 162, the first pump 197 and the heater 196 while part of the processing solution 166 is transported to the first stripping bath 151.

The third stripping bath 171 is a bath in which a processing solution 176 such as an organic solvent is contained and one substrate holder 80 can be stored so that the in-plane direction of the substrate is vertically oriented. The third stripping bath 171 has an outside bath 172 which receives the processing solution 176 overflowing from the third stripping bath 171, a heater 192 which heats the processing solution 176 from the outside bath 172, a second pump 193 (corresponding to an example of a second transport mechanism) which transports the processing solution 176 from the outside bath 172 to the heater 192, a supply port 164 through which the processing solution 176 heated by the heater 192 is supplied into the third stripping bath 171, a shutter for opening and closing the openings of the third stripping bath 171 and the outside bath 172, which is the shutter 104 shown in FIGS. 18 and 19, and a nitrogen supply port 179 through which nitrogen is supplied into the bath.

The outside bath 172 has a supply port 175 for supplying the unused processing solution into the outside bath 172. The outside bath 172 also has a discharge port 173 through which the processing solution in the outside bath 172 is discharged. Piping 191 communicating with the second pump 193 is connected to the discharge port 173. That is, the processing solution in the outside bath 172 is supplied to the third stripping bath 171 through the supply port 174 via the discharge port 173, the piping 191, the second pump 193 and the heater 192. The second piping 194 communicates with the second pump 193. Accordingly, part of the processing solution from the outside bath 172 transported by the second pump 193 is transported to the second stripping bath 161. The amount of the unused processing solution corresponding to the processing solution transported to the second stripping bath 161 by the second pump 193 is supplied from the supply port 175.

In the third stripping bath 171, the substrates W processed in the second stripping bath 161 are processed one after another. That is, the substrate holder 80 holding the substrate W is transferred from the second stripping bath 161 to the third stripping bath 171 with the lifter 70 (see FIG. 14) having the cover 90 (see FIGS. 15 and 16) to be immersed in the processing solution 176. Since the processing solution 176 is an unused processing solution, the amounts of resist components removed from the substrate W and contained in the processing solution 176 is smaller than those in the processing solution in the first stripping bath 151 and the processing solution in the second stripping bath 161 and has higher resist removal performance. Therefore, even the resist not removed in the first stripping bath 151 and in the second stripping bath 161 can be removed in the third stripping bath 171. After the substrate W is immersed in the processing solution 176 for a predetermined time period, the substrate holder 80 is taken out from the third stripping bath 171 and transferred to the rinse bath 181 with the lifter 70. The shutter 104 is closed during time periods other than a time period in which the substrate holder 80 is put in the third stripping bath 171 and a time period in which the substrate holder 80 is taken out from the third stripping bath 171. Diffusion of the processing solution atmosphere generated by evaporation of the processing solution, e.g., an organic solvent can thereby be inhibited.

While the resist on the substrate W is being removed in the third stripping bath 171, the second pump 193 continues supplying the processing solution 176 from the outside bath 172 to the third stripping bath 171 and to the second stripping bath 161. Accordingly, the processing solution 176 in the third stripping bath 171 circulates through the third stripping bath 171, the outside bath 172, the second pump 193 and the heater 192 while part of the processing solution 176 is transported to the second stripping bath 161.

The rinse bath 181 is a processing bath in which one substrate holder is stored and the substrate W is cleaned after removal of the resist from the substrate W in the third stripping bath 171. The rinse bath 181 has sprinkling portions 185 for sprinkling DIW and IPA to the substrate W, a supply port 184 for supplying DIW 187 into the bath, a shutter for opening and closing the opening of the rinse bath 181, which is the shutter 104 shown in FIGS. 18 and 19, and a to-and-fro movement mechanism 186 for moving the substrate holder 80 to and fro in the vertical direction.

The rinse bath 181 further has an outside bath 182 which receives DIW 187 overflowing from the rinse bath 181, and a discharge port 183 which is provided in the outside bath 182, and through which DIW 187 in the outside bath 182 is discharged.

While the substrate W stored in the rinse bath 181 is being moved to and fro in the vertical direction together with the substrate holder 80, IPA is first sprinkled from the sprinkling portions 185 and DIW is thereafter sprinkled from the sprinkling portions 185. IPA has low surface tension and can spread easily on irregularities in the substrate surface. The processing solution attached to the substrate W surface is washed off thereby. Also, IPA and DIW are sprinkled to the entire substrate W surface as a result of moving the substrate W to and fro in the vertical direction with the to-and-fro movement mechanism 186, thus enabling the entire substrate W surface to be cleaned with efficiency. Further, after sprinkling of IPA and DIW, DIW 187 is supplied from the supply port 184 and the rinse bath 181 is filled with DIW 187. DIW 187 supplied from the supply port 184 overflows from the rinse bath 181 and flows into the outside bath 182. DIW 187 having flowed into the outside bath 182 is discharged through the discharge port 183.

While the substrate holders 80 are immersed in DIW 187, DIW 187 is supplied from the supply port 184 at a constant flow rate. Simultaneously, DIW 187 having flowed into the outside bath 182 is discharged through the discharge port 183. After immersion and cleaning of one substrate, DIW filling the rinse bath 181 is discharged.

The substrate dryer 31a has the same construction as that of the substrate dryer 31b shown in FIG. 21. That is, the substrate dryer 31a has a turntable 34 which supports the substrate W cleaned in the rinse bath 181 and rotates the substrate W along its in-plane direction, and a nozzle 35 from which DIW and vapor of IPA are supplied to the substrate W supported on the turntable 34.

The substrate W is supported and rotated at a predetermined speed by the turntable 34. Through the nozzle 35, each of DIW and vapor of IPA containing nitrogen is individually supplied to the substrate W surface. That is, the nozzle 35 is constituted by a nozzle for supplying DIW and a nozzle for supplying vapor of IPA. Supply orifices of the nozzle are moved to and fro from the center of the substrate W in a radial outward direction while DIW and vapor of IPA are being supplied. Uniform water film is thereby formed in the substrate W plane. Simultaneously, the water film is moved radially outward on the substrate W by centrifugal force and a force (Marangoni force) produced due to a surface tension gradient (difference) between IPA and DIW, thereby drying the substrate W surface.

Transfer of the substrate holder 80 among the first stripping bath 151, the second stripping bath 161, the third stripping bath 171 and the rinse bath 181 is performed with the lifter 70 shown in FIGS. 14 to 16. Transfer of the substrate holder 80 between the pre-wet bath 145a and the resist removing module 150 is performed by the substrate transfer device 50a shown in FIG. 1 and other figures.

As described above, the substrate processing apparatus 250 is provided with the first stripping bath 151, the second stripping bath 161 and the third stripping bath 171. Resist removal processing at the first stage is performed by spraying the processing solution to substrate W; resist removal processing at the second stage is performed by simultaneously immersing a plurality of substrates W in the processing solution; and resist removal processing at the final stage is performed by again immersing the substrate W in the processing solution. Thus, the resist formed on the substrate W is removed by stages and the resist on the substrate W can be finally removed substantially completely.

In the present embodiment, the substrate holder holding the substrate W is stored in each of the pre-wet baths 145a and 145b, the first stripping bath 151, the second stripping bath 161, the third stripping bath 171 and the rinse bath 181 so that the in-plane direction of the substrate W is vertically oriented. The footprint of the substrate processing apparatus 250 can thereby be reduced in comparison with the case where the substrate holder is stored so that the in-plane direction of the substrate W is horizontally oriented. Note that "the in-plane direction of the substrate W is vertically oriented" is not limited to the case where the in-plane direction of the substrate W is oriented completely in the vertical direction, but also includes a case where the in-plane direction of the substrate W has a slight angle to the vertical direction. That is, it means that the above-described processing baths are of a vertical type.

In the present embodiment, the processing solution (organic solvent) used in the third stripping bath 171 is transported to the second stripping bath 161 by the second pump 193 through the second piping 194, and the processing solution used in the second stripping bath 161 is transported to the first stripping bath 151 by the first pump 197 through the first piping 198. That is, the processing solution is reused in each bath and the amount of the high-priced processing solution used can thereby be reduced.

In the first stripping bath 151, processing for roughly removing the resist formed on the substrate W, including removal of attached materials, e.g., one produced by dry etching, is performed. To effectively remove attached materials, e.g., one produced by dry etching, a physical impact caused by sprinkling an organic solvent to the substrate W is also used in the first stripping bath 151. In the first stripping bath 151, the organic solvent used in the third stripping bath 171 and in the second stripping bath 161 is used to perform rough removal processing. In the second stripping bath 161, the substrate is immersed in the organic solvent used in the third stripping bath 171. The time period for which removal processing is performed in the second stripping bath 161 is longer than those in the other baths, and a great part of the resist to be removed is removed in the second stripping bath 161. The organic solvent used in the second stripping bath 161 contains large amounts of components of the removed resist. When the substrate W is lifted up out of the second stripping bath 161, the organic solvent including components of the resist is attached to the substrate surface and the attached materials are again adhered to the substrate when the temperature is lowered. There is a need to finally remove the attached materials. In the third stripping bath 171, therefore, the substrate is immersed in the new organic solvent to dissolve the resist components attached to the substrate lifted up out of the second stripping bath 161, thus completing the resist removal process.

The present embodiment has been described by assuming that the to-and-fro movement mechanism for moving the substrate holder 80 to and fro in the vertical direction in the bath is provided on each of the pre-wet baths 155a and 155b and the rinse bath 181. However, the present invention is not limited to this. The to-and-fro movement mechanism may be provided on at least one of the first stripping bath 151, the second stripping bath 161 and the third stripping bath 171. If the to-and-fro movement mechanism is provided on the first stripping bath 151, the organic solvent is sprinkled to the entire substrate W surface as a result of moving the substrate W to and fro, thereby enabling the resist formed on the substrate W surface to be entirely removed. If the to-and-fro movement mechanism is provided on the second stripping bath 161 or the third stripping bath 171, a flow of the organic solvent is formed on the substrate and the organic solvent is agitated as a result of moving the substrate W to and fro, thereby further improving the resist removal efficiency.

Next, the substrate holder shifting mechanism used for the second stripping bath 161 shown in FIG. 24 will be described. FIG. 25 is a schematic perspective view of the second stripping bath 161 having the substrate holder shifting mechanism. In FIG. 25, the construction of the second stripping bath 161 is illustrated by being simplified. For example, the lid part 109 and the shutters 104 shown in FIG. 20 and the outside bath 162 shown in FIG. 23 are omitted.

As illustrated, the second stripping bath 161 with opening 161a is provided with a pair of substrate holder shifting mechanisms 200 disposed on opposite sides thereof. Each substrate holder shifting mechanism 200 includes a fixed plate 167 fixed on an outer wall of the second stripping bath 161, a rail 201 provided at an outer position relative to the fixed plate 167, a slider 202 (corresponding to an example of a horizontal drive mechanism) constructed so as to be horizontally slidable on the rail 201, a support base 204 fixed on an upper surface of the slider 202, an air cylinder 205 (corresponding to an example of a vertical drive mechanism) supported on the support base 204, a shaft 206 constructed so as to be vertically extensible/contractible by the air cylinder 205, and a substrate holder support part 207 connected to the shaft 206.

A substrate holder mount 168 having a plurality of recesses 170 for placement of the arm portion 82-1 or 82-2 (see FIG. 3) of the substrate holder 80 to be put in the opening 161a is formed in the upper end of the fixed plate 167. The substrate holder support part 207 has in its upper surface a plurality of recesses 208 for supporting from below the arm portion 82-1 or 82-2 placed on the substrate holder mount 168.

The substrate holder support part 207 is vertically driven with extension/contraction of the shaft 206 in the vertical direction. The position in height direction of the recesses 208 when the substrate holder support part 207 is at its lowest position is lower than the position in height direction of the recesses 170 of the substrate holder mount 168. The position in height direction of the recesses 208 when the substrate holder support part 207 is at its highest position is higher than the position in height direction of the recesses 170 of the substrate holder mount 168. That is, when the substrate holder support parts 207 are moved to the highest position, the arm portions 82-1 and 82-2 of the substrate holder 80 are supported by the recesses 208 of the substrate holder support parts 207. When the substrate holder support parts 207 are moved to the lowest position, the arm portions 82-1 and 82-2 of the substrate holder 80 are supported by the recesses 170 of the substrate holder mounts 168.

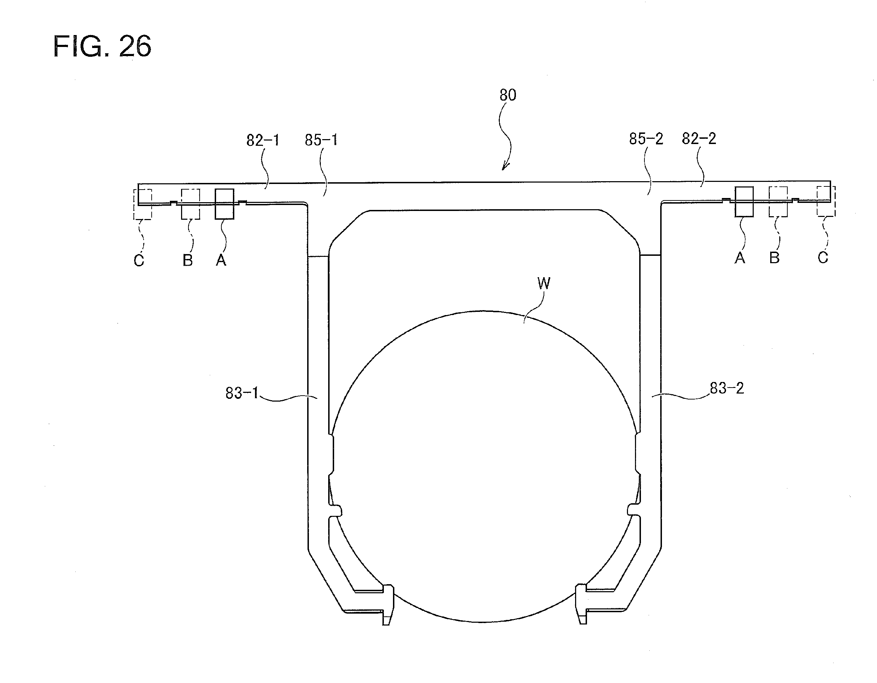

FIG. 26 is a plan view of the substrate holder 80 indicating positions on the arm portions 82-1 and 82-2 of the substrate holder 80 to be brought into contact with the substrate holder mounts 168 and the substrate holder support parts 207. Positions C indicated in FIG. 26 are positions at which the arm portions 82-1 and 82-2 are supported by the lifter 70. The recesses 170 of the substrate holder mounts 168 support the arm portions 82-1 and 82-2 at innermost positions A on the arm portions 82-1 and 82-2. The recesses 208 of the substrate holder support parts 207 support the arm portions 82-1 and 82-2 at positions B between the positions A and the positions C.

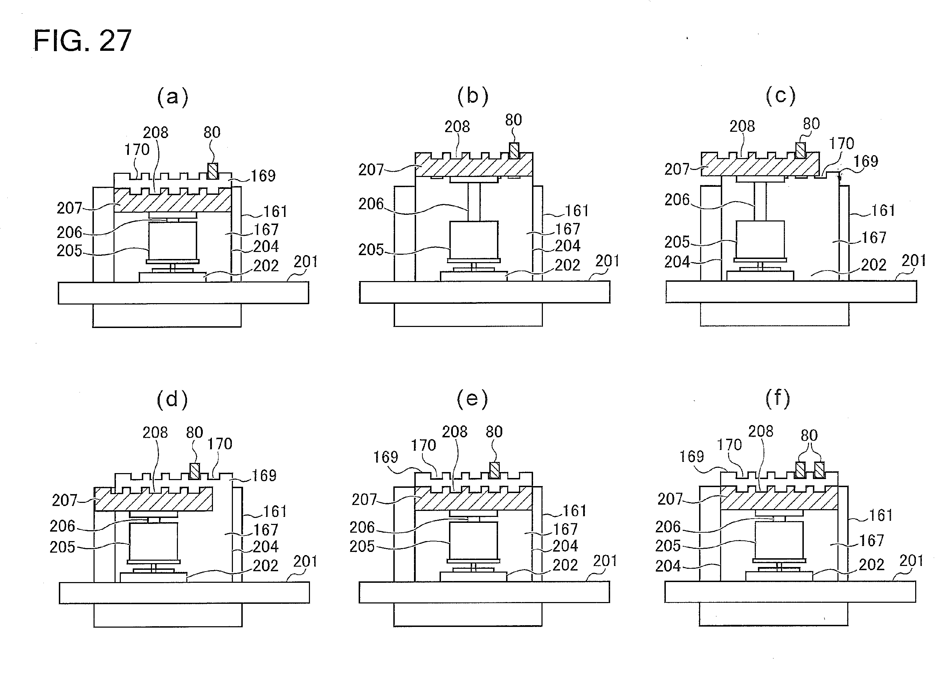

FIGS. 27A to 27F are diagrams showing steps in which the substrate holder shifting mechanisms 200 shift the substrate holder 80. First, in the step shown in FIG. 27A, the substrate holder 80 is stored in the second stripping bath 161 through the inlet opening portion 107 (see FIG. 20) with the lifter 70 (see FIG. 11) and is placed in the recesses 170 of the substrate holder mounts 168. At this time, the substrate holder support parts 207 are lower in position than the substrate holder mounts 168. The positions of the plurality of recesses 208 of the substrate holder support parts 207 in a horizontal direction coincide with the positions of the plurality of recesses 170 of the substrate holder mounts 168.

In the step shown in FIG. 27B, the air cylinders 205 are driven to slide the shafts 206 in the vertical upward direction. With this slide, the substrate holder support parts 207 are moved upward and the recesses 208 receive the substrate holder 80 from the substrate holder mounts 168. Subsequently, in the step shown in FIG. 27C, the slider 202 are horizontally moved to horizontally move the substrate holder 80. When the substrate holder support parts 207 are moved upward from the step shown in FIG. 27B to the step shown in FIG. 27C, the upper end of the substrate W held by the substrate holder 80 does not emerge from the liquid surface of the processing solution 166 in the second stripping bath 161. In the step shown in FIG. 27D, the air cylinders 205 are driven to slide the shafts 206 in the vertical downward direction. With this slide, the substrate holder support parts 207 are moved downward and the substrate holder 80 is delivered from the substrate holder support parts 207 to the recesses 170 of the substrate holder mounts 168. The substrate holder 80 is thereby transferred from the recesses 170 in which it is first placed to the recesses 170 adjacent to these.

In the step shown in FIG. 27E, the sliders 202 are slid to be returned to the initial position. Subsequently, in the step shown in FIG. 27F, another substrate holder 80 is stored in the second stripping bath 161 through the inlet opening portion 107 (see FIG. 20) with the lifter 70 (see FIG. 11) and is placed in the recesses 170 of the substrate holder mounts 168.

The steps shown in FIGS. 27B to 27E are repeated to move the substrate holder 80 over the recesses 170 in the same way. The substrate is thereby moved in the second stripping bath 161 while being kept in the state of being immersed in the processing solution 166. The substrate holder 80 is finally taken out from the second stripping bath 161 through the outlet opening portion 108 (see FIG. 20) with the lifter 70 (see FIG. 11).

The second stripping bath 161 is designed to increase the time period for immersion in the organic solvent and to enable a plurality of substrates to be simultaneously processed in parallel with each other, is constructed as a large bath, and stores a plurality of substrate holders. On the other hand, from the viewpoint of preventing diffusion of a chemical solution atmosphere around the bath, it is desirable to make the opening of the bath as small as possible. In the present embodiment, the opening is restricted to the inlet opening portion 107 and the outlet opening portion 108 and the opening region other than these opening portions is covered with the lid part 109 (see FIG. 20). The second stripping bath 161 therefore has the substrate holder shifting mechanisms 200 and is made capable of shifting the substrate holder 80. Further, a mechanism which not only moves the substrate W horizontally at a constant height in a simple way but also performs an operation accompanied with an up/down action is adopted to promote agitation of the processing solution and improve the effect of making uniform the temperature distribution in the high-temperature processing solution in the bath.

As described above, the second stripping bath 161 is provided with the substrate holder shifting mechanisms 200 which simultaneously shift a plurality of stored substrates horizontally, thereby enabling substrate holders 80 stored through the inlet opening portion 107 (see FIG. 20) to be successively taken out through the outlet opening portion 108 in the order in which the substrate holders are stored, and enabling all substrates W immersed in a processing solution such as an organic solvent to be immersed for the same time period. Variations in the degree of removal the resist from the substrates W can thereby be reduced.

The second stripping bath 161 also has the substrate holder mounts 168 on which the substrate holder 80 is placed, and each substrate holder shifting mechanism 200 has the substrate holder support part 207, the air cylinder 205 and the shaft 206 for driving the substrate holder support part 207 in a vertical direction and the slider 202 for driving the substrate holder support part 207 in a horizontal direction. With this arrangement, the substrate holder 80 can be shifted in the horizontal direction with stability in the second stripping bath 161.

The substrate holder shifting mechanisms 200 are provided not only for the second stripping bath 161 but also for the second rinse bath 141 in the etching unit 110.

The embodiment of the present invention is described above, but the aforementioned embodiment of the present invention is for facilitating understanding of the present invention, and does not restrict the present invention. The present invention can be modified and improved without departing from the scope of the invention, and the present invention includes equivalents of the present invention as a matter of course. Further, the respective components described in the claims and the description can be optionally combined or omitted within the range where at least part of the aforementioned problem can be solved, or in the range where at least part of the effect is provided.
- 50: Substrate transfer device
- 50a: Substrate transfer device
- 50b: Substrate transfer device
- 51: Transfer mechanism
- 52: Travel motor
- 54: Grasping mechanism
- 55: Rotary motor
- 66: Processing bath
- 70: Lifter
- 72: Horizontal moving mechanism
- 90: Cover
- 91: Fixed rear side part
- 92: Fixed front side part
- 93: Movable cover part
- 96: Hinge
- 97: Piston cylinder mechanism
- 100: Opening
- 101: Exhaust mechanism
- 102: Lid part
- 104: Shutter
- 107: Inlet opening portion
- 108: Outlet opening portion
- 109: Lid part
- 115a: Pre-wet bath
- 115b: Pre-wet bath
- 117: To-and-fro movement mechanism
- 121: Etching bath
- 131: First rinse bath
- 132: To-and-fro movement mechanism
- 141: Second rinse bath
- 145a: Pre-wet bath
- 145b: Pre-wet bath
- 147: To-and-fro movement mechanism
- 151: First stripping bath
- 153: Sprinkling mechanism
- 161: Second stripping bath
- 168: Substrate holder mount
- 171: Third stripping bath
- 181: Rinse bath
- 186: To-and-fro movement mechanism
- 193: Second pump
- 194: Second piping
- 197: First pump
- 198: First piping
- 200: Substrate holder shifting mechanism
- 202: Slider
- 205: Air cylinder
- 206: Shaft
- 207: Substrate holder support part

## Claims

1. A substrate processing apparatus (250), comprising:
a processing bath (66) for storing a substrate holder (80) holding a substrate (W) and for processing the substrate (W);
a lifter (70) configured to support the substrate holder (80), store the substrate holder (80) in the processing bath (66), and take out the substrate holder (80) from the processing bath (66); and
a cover (90) attached to the lifter and configured to cover the periphery of the substrate holder (80) taken out from the processing bath (66) by the lifter (70).

2. The substrate processing apparatus according to claim 1, wherein the cover (90) has a movable part (93) and a cover drive section (97) configured to open and close the cover (90) by driving the movable part (93).

3. The substrate processing apparatus according to claim 2, further comprising a transferring device (50a, 50b) configured to transfer the substrate holder (80) and deliver the substrate holder (80) to the lifter (70) or receive the substrate holder (80) from the lifter (70),
wherein the cover drive section (97) opens the cover (90) by driving the movable part (93) when the transferring device (50a, 50b) delivers the substrate holder (80) to the lifter (70) or receives the substrate holder (80) from the lifter (70).

4. The substrate processing apparatus according to claim 3,
wherein the cover (90) has a hinge (96) with which the one end of the movable part (93) is turnably attached, and
the cover drive section (97) opens and closes the cover (90) by turning the movable part (93) turnably attached to the hinge (96).

5. The substrate processing apparatus according to claim 3 or 4, wherein the transferring device (50a, 50b) has a grasping section (54) configured to grasp the substrate holder (80), and a transferring section (51) configured to transfer the substrate holder (80) grasped by the grasping section (54),
the grasping section (54) is configured to grasp the substrate holder (80) with a surface of the substrate (W) oriented horizontally, and
the transferring section (51) is configured to transfer the substrate holder (80) above the cover (90), with the surface of the substrate (W) oriented horizontally.

6. The substrate processing apparatus according to claim 5, wherein the transferring device (50a, 50b) has a drive section (55) configured to drive and turn the grasping section (54) grasping the substrate holder (80) so that the surface of the substrate (W) is vertically oriented, and
the lifter (70) is configured to receive from the transferring device (50a, 50b) the substrate holder (80) grasped in such a state that the surface of the substrate (W) is vertically oriented.

7. The substrate processing apparatus according to any one of claims 1 to 6, wherein the cover (90) is positioned above the processing bath (66), and
the cover (90) has in its bottom portion an opening (100) for storing the substrate holder (80) in the processing bath (66) positioned below or taking out the substrate holder (80) from the processing bath (66).

8. The substrate processing apparatus according to any one of claims 1 to 7, further comprising an exhaust section (101) configured to exhaust gas from the interior of the cover (90).

9. The substrate processing apparatus according to any one of claims 1 to 8, further comprising a horizontal moving mechanism (72) configured to move the lifter (70) in a horizontal direction.

10. The substrate processing apparatus according to any one of claims 1 to 9, wherein the processing bath (66) has a shutter (104) capable of opening and closing the opening of the processing bath.

11. The substrate processing apparatus according to any one of claims 1 to 10, wherein the processing bath (66) is a bath for processing the substrate by using an organic solvent.

12. A resist removing unit, comprising:
a first resist removing bath (151) for storing a substrate holder (80) holding a substrate (W) and for processing the substrate (W);
a second resist removing bath (161) for storing a plurality of the substrate holders (80) holding substrates (W) processed in the first resist removing bath (151) and for processing the substrates (W); and
a third resist removing bath (171) for storing the substrate holder (80) holding the substrate (W) processed in the second resist removing bath (161) and for processing the substrate (W),
wherein the first resist removing bath (151) has a spraying section (153) configured to spray a processing solution to the substrate (W), and
each of the second resist removing bath (161) and the third resist removing bath (171) contains a processing solution (166, 176) in which the substrate (W) is to be immersed.

13. The resist removing unit according to claim 12, wherein each of the first resist removing bath (151), the second resist removing bath (161) and the third resist removing bath (171) stores the substrate holder (80) holding the substrate (W) in such a manner that a surface of the substrate W is vertically oriented.

14. The resist removing unit according to claim 12 or 13, further comprising a substrate holder shifting mechanism (200) configured to simultaneously move in a horizontal direction the plurality of the substrate holders (80) stored in the second resist removing bath (161).

15. The resist removing unit according to claim 14, wherein the second resist removing bath (161) has a mount (168) on which the substrate holder (80) is mounted, and
the substrate holder shifting mechanism (200) has a support part (207) for supporting the substrate holder (80) mounted on the mount (168), a vertical drive mechanism (205) configured to drive the support part (207) in a vertical direction, and a horizontal drive mechanism (202) configured to drive the support part in a horizontal direction.

16. The resist removing unit according to any one of claims 12 to 15, wherein the second resist removing bath (161) has an opening (161a) for storing the substrate holder (80) and a lid part (109) for covering the opening (161a), and
the lid part (109) has an inlet opening portion (107) for storing the substrate holder (80) in the opening (161a), an outlet opening portion (108) for taking out the substrate holder (80) from the opening (161a), and shutters (104) for opening and closing the inlet opening portion (107) and the outlet opening portion (108).

17. The resist removing unit according to any one of claims 12 to 16, further comprising:
first piping (198) connecting the first resist removing bath (151) and the second resist removing bath (161);
second piping (194) connecting the second resist removing bath (161) and the third resist removing bath (171);
a first transport mechanism (197) configured to transport a processing solution used in the second resist removing bath (161) to the first resist removing bath (151) through the first piping (198); and
a second transport mechanism (193) configured to transport a processing solution used in the third resist removing bath (171) to the second resist removing bath (161) through the second piping (194).

18. The resist removing unit according to any one of claims 12 to 17, wherein at least one of the first resist removing bath (151), the second resist removing bath (161) and the third resist removing bath (171) has a to-and-fro movement mechanism configured to move the stored substrate holder (80) to and fro in a vertical direction.
